(19) Europäisches Patentamt
European Patent Office
Office européen des brevets

(11) **EP 2 984 508 B1**

(12) **EUROPÄISCHE PATENTSCHRIFT**

(45) Veröffentlichungstag und Bekanntmachung des Hinweises auf die Patenterteilung:
**29.05.2019   Patentblatt 2019/22**

(21) Anmeldenummer: **14715276.3**

(22) Anmeldetag: **03.04.2014**

(51) Int Cl.:
*G02B 5/00* *(2006.01)*   *C23C 14/34* *(2006.01)*
*C23C 14/08* *(2006.01)*   *F24S 70/25* *(2018.01)*
*F24S 70/30* *(2018.01)*   *G02B 1/11* *(2015.01)*
*C23C 14/35* *(2006.01)*

(86) Internationale Anmeldenummer:
**PCT/EP2014/056668**

(87) Internationale Veröffentlichungsnummer:
**WO 2014/166803 (16.10.2014 Gazette 2014/42)**

(54) **LICHT ABSORBIERENDE SCHICHT UND DIE SCHICHT ENTHALTENDES SCHICHTSYSTEM, VERFAHREN ZUR HERSTELLUNG DES SCHICHTSYSTEMS UND DAFÜR GEEIGNETES SPUTTERTARGET**

LIGHT-ABSORBING LAYER AND LAYER SYSTEM CONTAINING THE LAYER, PROCESS FOR PRODUCING THE LAYER SYSTEM AND SPUTTER TARGET SUITABLE THEREFOR

COUCHE ABSORBANT LA LUMIÈRE ET SYSTÈME MULTICOUCHE CONTENANT LADITE COUCHE, PROCÉDÉ DE PRODUCTION DU SYSTÈME MULTICOUCHE ET CIBLE DE PULVÉRISATION APPROPRIÉE À CET EFFET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.04.2013   DE 102013103679**

(43) Veröffentlichungstag der Anmeldung:
**17.02.2016   Patentblatt 2016/07**

(73) Patentinhaber: **Materion Advanced Materials Germany GmbH**
**63755 Alzenau (DE)**

(72) Erfinder:
- **SCHLOTT, Martin**
  **63075 Offenbach (DE)**
- **KASTNER, Albert**
  **63457 Hanau (DE)**
- **SCHULTHEIS, Markus**
  **36103 Flieden (DE)**
- **WAGNER, Jens**
  **60322 Frankfurt (DE)**
- **LEE, Suk-Jae**
  **Gyeonggi-do 448-536 (KR)**
- **KAHLE, Ben**
  **63755 Alzenau (DE)**

(74) Vertreter: **Kador & Partner PartG mbB**
**Corneliusstraße 15**
**80469 München (DE)**

(56) Entgegenhaltungen:
EP-A2- 1 201 616         DE-A1-102007 062 876
JP-A- 2002 206 166       US-A- 6 048 621
US-A1- 2007 000 537

**Beschreibung**

Technisches Gebiet der Erfindung

Die Erfindung betrifft eine Licht absorbierende Schicht, die bei einer Wellenlänge von 550 nm einen Absorptionsindex kappa von mehr als 0,7 aufweist sowie ein Schichtsystem, das eine derartige Licht absorbierende Schicht enthält.

Weiterhin betrifft die Erfindung ein Verfahren zur Herstellung einer derartigen Schicht oder eines Schichtsystems sowie ein Sputtertarget zum Einsatz in diesem Verfahren.

Stand der Technik

Licht absorbierende Schichtsysteme werden beispielsweise durch Abscheiden aufeinanderfolgender Schichten mittels Kathodenzerstäubung (Sputtern) erzeugt. Dabei werden Atome oder Verbindungen aus einem Festkörper, dem Sputtertarget, durch Beschuss mit energiereichen Ionen (üblicherweise Edelgasionen) herausgelöst und gehen in die Gasphase über. Die in der Gasphase befindlichen Atome oder Moleküle werden schließlich durch Kondensation auf einem in der Nähe des Sputtertargets befindlichen Substrat abgeschieden und bilden dort eine Schicht aus. Beim "Gleichspannungssputtern" oder "DC-Sputtern" (direct current sputtering) wird zwischen dem als Kathode geschalteten Target und einer Anode (häufig das Anlagengehäuse) eine Gleichspannung angelegt. Durch Stoßionisation von Inertgasatomen bildet sich im evakuierten Gasraum ein Niederdruckplasma, dessen positiv geladene Bestandteile durch die angelegte Gleichspannung als dauerhafter Teilchenstrom in Richtung auf das Target beschleunigt werden und beim Aufprall Teilchen aus dem Target herausgeschlagen, die sich wiederum in Richtung auf das Substrat bewegen und sich dort als Schicht niederschlagen.

Das DC-Sputtern erfordert ein elektrisch leitfähiges Targetmaterial, da sich andernfalls das Target infolge des dauerhaften Stroms elektrisch geladener Teilchen aufladen und damit das Gleichspannungsfeld kompensiert würde. Andererseits ist gerade diese Sputtermethode geeignet, Schichten besonders hoher Qualität auf wirtschaftliche Weise zu liefern, so dass ihr Einsatz angestrebt wird. Dies trifft auch für das technologisch verwandte MF-Sputtern zu, bei dem zwei Sputtertargets wechselseitig im kHz-Rhythmus als Kathode und Anode geschaltet werden.

Licht absorbierende Schichtsysteme werden für verschiedene Anwendungen eingesetzt, wie etwa als Solarabsorberschichten für solarthermische Anwendungen oder sogenannte "black matrix"-Schichten in Verbindung mit Flüssigkristall-Displays.

Aus der EP 2 336 811 A1 ist eine Schichtenfolge aus einem Aluminium-Substrat, einer Zwischenschicht aus $Al_2O_3$ und einem Licht absorbierenden Schichtsystem bekannt. Das Schichtsystem besteht aus einer unteren Schicht aus einem Ti-Al-Mischoxid oder -nitrid oder -oxinitrid mit der allgemeinen Summenformel: TiAlqOxNy), das unterstöchiometrische Gehalte an Sauerstoff und Stickstoff enthalten kann und die die eigentliche Absorberschicht bildet, und aus einer oberen Schicht aus stöchiometrischem oder aus unterstöchiometrischem $SiO_2$.

Bei den Solarabsorberschichten umfasst der Schichtaufbau typischerweise eine Cermetschicht und eine darunter liegende metallische Abschlussschicht, die als selektiver Reflektor dient. In der Cermetschicht sind in einer keramischen Matrix metallische oder andere elektrisch leitfähige Partikel eingelagert, die typischerweise einen Durchmesser im Bereich von 5 bis 30 nm haben. Diese Schichtstapel weisen im solaren Spektralbereich (um 350 bis 1500 nm) einen hohen Absorptionsgrad auf, während ihr Absorptionsgrad im infraroten Spektralbereich gering ist. Für die industrielle Fertigung dieser Schichtsysteme sind galvanische Beschichtungstechniken und PVD-Verfahren gebräuchlich. Beispiele für solche Schichtstapel sind Ni/NiO + Al und $TiNx/TiO_2$ + Cu. Eine aktuelle Übersicht gibt "Kennedy, C.E.; - Review of Mid- to High-Temperature Solar Selective Absorber Materials; NREL Technical Report (July 2002)".

Aus der EP 2 116 631 A1 ist ein Sputtertarget zur Herstellung einer ZnO:Me2-Schicht oder einer TiO:Me2-Schicht bekannt. Um den Sputterprozess zu beschleunigen und zu stabilisieren wird ein Sputtertarget eingesetzt, das eine Matrix aus einem unterstöchiometrischen Zink- oder Titan-Oxid, in der zusätzlich ein zweites Metall Me2 eingelagert ist, bildet, wobei Me2 für Al oder Niob steht.

Die US 2007/0071985 A1 beschreibt eine Vielzahl von Materialzusammensetzungen, insbesondere für ein Sputtertarget. Die Zusammensetzungen beinhalten unter anderem Mischoxide auf Basis von ZnO (auch mit Indiumoxid, Zinnoxid, Aluminiumoxid und Galliumoxid) und Molybdän(IV)Oxid (MoO2). Der Anteil an $MoO_2$ wird zwischen 0,1 und 60 Mol.-% angegeben. Die Dichten des Targetmaterials schwanken zwischen etwa 77% und 95% der theoretischen Dichte. Molybdänoxid in Form von $MoO_2$ ist ein stöchiometrisches Oxid des Molybdäns, wenn auch nicht das Oxid mit dem höchstmöglichen Sauerstoffgehalt $MoO_3$. Es wird dem Basisoxid zur Verbesserung der Leitfähigkeit beigemischt, die aber de facto - wie etwa im Mischoxidsystem ZnO:MoO2 - nur für geringe Anteile um etwa 5-10mol% $MoO_2$ gute Wert erreicht.

Die Herstellung des Targets erfolgt durch Heißpressen in Grafitformen unter Vakuum oder durch Sintern an Luft.

Die Schichtabscheidung unter Einsatz der Targets erfolgt unter geringer Zugabe von Sauerstoff im Abscheidegas. Der Sauerstoffdruck wird unabhängig vom $MoO_2$-Gehalt des Targetwerkstoffs auf 10 mTorr eingestellt und genügt, um den bei der Schichtabscheidung üblicherweise beobachteten Sauerstoffverlust auszugleichen.

Die aus dem Target erzeugten Schichten sind elektrisch leitfähig und zeigen eine Transmission von mindestens 80%. Sie stellen Alternativen zu ansonsten üblichen transparenten und leitfähigen Schichten dar, beispielsweise ITO-Schichten.

In der CN 101158028 A ist ein Sputterverfahren zur Herstellung einer Schicht beschrieben, die als "ZMO transparent conductive film" bezeichnet wird. Der Targetwerkstoff besteht aus Zink, in dem Mo-Metallstücke eingesetzt sind (Zincmolybdenum metal inserted target). Der Molybdän-Anteil wird mit 0,5 bis 12,5 % bezogen auf die Zinkmasse angegeben

Auch dieses Target dient zur Herstellung eines transparenten und leitfähigen Filmes. Dieser wird durch reaktives DC-Magnetron-Sputtern in einer Sputter-Atmosphäre erzeugt, die Argon und Sauerstoff enthält. Der Sauerstoffgehalt liegt im Bereich von 4 bis 10%.

Die JP 2002-206166 A beschreibt einen Blackmatrix-Werkstoff mit der Hauptkomponente Kupferoxid, dem als weitere Komponente Silberoxid hinzugefügt ist, das als "Schwärzungskomponente" dient. Der Werkstoff kann zur Verringerung der Reflektivität zusätzlich in einer Menge von 0,1 bis 5 Gew.-% Oxide der folgenden Metalle enthalten: In, Ti, Zr, Sn, Zn, Ta, W, Mo, Ni.

Aus der US 6,048,621 A ist ein Sonnenschutzglas bekannt, das mit einem Schichtsystem aus einer wärmeabsorbierenden Schicht und einer Schicht mit niedriger Emission belegt ist. Die gering emittierende Schicht besteht beispielsweise aus dotiertem Zinnoxid oder aus dotiertem Indiumoxid. Die wärmeabsorbierende Schicht kann aus unterstöchiometrischen $WO_{2,98}$ gebildet sein.

## Technische Aufgabenstellung

Bei der Herstellung der Schichtsysteme und bei ihrer Implementierung in komplexe Schichtaufbauten sind Trocken- oder Nassätzvorgänge erforderlich. Cermet-Schichtsysteme sind in der Regel jedoch nur schwierig ätzbar, da Bereiche aus metallischer Phase andere Ätzmittel benötigen als die oxidische Matrix. Auch Plasmaätzen hat sich als schwierig erwiesen. So wird beispielsweise bei Kombinationen aus einem Oxid und einem Edelmetall überwiegend das Oxid geätzt, so dass Metallpartikel übrig bleiben und die Sputteranlage und nachfolgende Substrate kontaminieren können.

Zum nasschemischen Ätzen oxidischer Bestandteile wird häufig Flusssäure benötigt, die gesundheitsschädlich und nur unter hohem Aufwand handzuhaben ist. Die vor allem bis zur Substratgeneration 5 eingesetzten Cr-basierten "black matrix Schichten" weisen außerdem den Nachteil auf, dass beim nasschemischen Ätzen giftige Cr-VI Verbindungen entstehen können.

Aus den oben erörterten Gründen sind Schichtstrukturen erwünscht, die eine hohe Absorption und geringe Reflektion im sichtbaren Spektralbereich zeigen und die sich ohne das Entstehen giftiger Substanzen und ohne Partikelrückstände unter Einsatz einfacher verdünnter Säuren ätzen lassen. Metallische Schichten oder Schichtlagen erfüllen diese Voraussetzung aus den oben genannten Gründen nicht.

Andererseits sollen die Schichten aus Qualitätserwägungen und wirtschaftlichen Gründen vorzugsweise durch DC- oder MF-Sputtern herstellbar sein, was einen elektrisch leitenden Targetwerkstoff voraussetzt.

Der Erfindung liegt daher die Aufgabe zugrunde, eine Licht absorbierende Schicht und ein die Schicht enthaltendes Schichtsystem anzugeben, das diese Anforderungen erfüllt.

Weiterhin liegt der Erfindung die Aufgabe zugrunde, ein Verfahren zur Herstellung des erfindungsgemäßen Schichtsystems sowie ein dafür geeignete Sputtertarget bereitzustellen.

## Allgemeine Beschreibung der Erfindung

## Die erfindungsgemäße Licht absorbierende Schicht

Hinsichtlich der Licht absorbierenden Schicht wird diese Aufgabe ausgehend von einer Schicht der eingangs genannten Gattung erfindungsgemäß durch eine Schicht gelöst,

- mit einer oxidischen Matrix, basierend auf einer Basiskomponente K1, ausgewählt aus der Gruppe bestehend aus Zinkoxid, Zinnoxid und/oder Indiumoxid, und auf einer Zusatzkomponente K3, die die Basiskomponente K1 zu einem Anteil "y" zwischen 0 und 75 Gew.-% ersetzt und die ausgewählt ist aus der Gruppe bestehend aus Nioboxid, Hafniumoxid, Titanoxid, Tantaloxid, Vanadiumoxid, Yttriumoxid, Zirkonoxid, Aluminiumoxid und Mischungen davon,

- wobei in der Matrix eine Schwärzungskomponente K2 verteilt ist, ausgewählt aus der Gruppe bestehend aus Molybdän, Wolfram und Mischungen und Legierungen davon, wobei die Schwärzungskomponente K2 entweder als Metall oder als unterstöchiometrisch-oxidische oder als unterstöchiometrisch-oxinitridische Verbindung des Metalls vorliegt, derart, dass der Schichtwerkstoff einen Reduktionsgrad aufweist, der durch einen Sauerstoffgehalt von maximal 65 % des stöchiometrisch maximalen Sauerstoffgehalts definiert ist, und wobei der Anteil "x" der Schwärzungskomponente K2 - berechnet aus dem Gewicht ihres elementaren Anteils bezogen auf das Gewicht des Schichtwerkstoffs im Bereich zwischen 20 und 50 Gew.-% liegt.

Die Licht absorbierende Schicht soll für einen Betrachter optisch nicht transparent, also undurchsichtig erscheinen. Die Lichtabsorption kann durch lichtstreuende oder absorbierende Einlagerungen von Partikeln oder Ausscheidungen in einer ansonsten transparenten Schichtmatrix erhalten werden. Werden derartige Schichten im weiteren Fertigungsprozess einem Ätzvorgang unterworfen, können jedoch Partikel oder Ausscheidungen ein anderes Ätzverhalten zeigen als die Schichtmatrix und beim Ätzen des Schichtsystems zu einer unerwünschten Partikelbildung führen. Dies ist insbesondere bei schwer ätzbaren Metallpartikeln der Fall, wie etwa bei Edelmetallpartikeln.

Um dies zu vermeiden, ist bei der erfindungsgemäßen Schicht vorgesehen, dass sie aus mindestens zwei Komponenten K1 und K2 besteht, wobei die Komponente K2 als "Schwärzungskomponente" dient in dem Sinne, dass sie als unterstöchiometrisches Oxid (mit Sauerstofffehlstellen) oder unterstöchiometrisches Oxinitrid (mit Sauerstoff- oder Stickstofffehlstellen) oder in metallischer Form vorliegt und dadurch über eine Elektronenkonfiguration mit freien Valenzen verfügt, die die gewünschte Lichtabsorption hervorrufen. Diese gelingt nicht, wenn die Komponente K2 in einem durch Stöchiometrie bestimmten Oxidationszustand vorliegt, wie etwa als $MoO_2$ oder als $WO_2$, auch wenn es sich dabei nicht um ihren jeweiligen maximal möglichen Oxidationsgrad handelt. Als chemische Summenformel kann der Reduktionsgrad beschrieben werden mit: $K2\text{-}O_{2\text{-}w}$ mit: $O < w \leq 2$).

Insgesamt liegt erfindungsgemäß somit kein volloxidischer Schichtwerkstoff vor, sondern ein oxidischer oder oxinitridischen Schichtwerkstoff mit unterstöchiometrischem Sauerstoffgehalt, der definitionsgemäß durch einen Sauerstoffgehalt von maximal 65 % des theoretisch maximal möglichen, stöchiometrischen Sauerstoffgehalts definiert ist. Im Hinblick auf eine optimale Absorption liegt der Sauerstoffgehalt zwischen 30 und 65 %, besonders bevorzugt zwischen 40 und 60 % des theoretisch maximal möglichen Sauerstoffgehalts.

Die Basiskomponente K1 ist ausgewählt aus der Gruppe: Zinn, Indium und/oder Zink. Diese Komponenten liegen im Schichtwerkstoff in der Regel in oxidischer Form vor. Die Schwärzungskomponente K2 liegt entweder als leicht ätzbare oxidische beziehungsweise oxinitridische Metallverbindung mit unterstöchiometrischem Sauerstoffgehalt oder in metallischer Form vor, wobei dafür eines oder mehrere der folgenden Metalle in Betracht kommen, nämlich Wolfram, Molybdän und Mischungen und Legierungen dieser Substanzen. Legierungen auf Basis von Mo und/oder W, die Zuschläge in Form von Elementen der CAS-Gruppen IVb, Vb und VIb enthalten (Ti, V, Cr, Zr, Nb, Hf, Ta) zeigen optische Eigenschaften, die denjenigen der reinen Metalle W und Mo beziehungsweise den Mischungen dieser reinen Metalle gleichen.

Die Licht absorbierende Schicht enthält somit ein unterstöchiometrisches Oxid oder ein unterstöchiometrischen Oxinitrid, das unbesetzte O- oder N-Valenzen hat. Im Fall der unterstöchiometrischen oxinitridischen Schwärzungskomponente ist ein kleiner Teil (vorzugsweise maximal 15%) der Sauerstoffplätze durch Stickstoff ersetzt.

Weitab ihrer stöchiometrischen Zusammensetzung vorliegende Substanzen zeigen eine Anzahl von Sauerstoffmangeldefekten, die sich spektroskopisch anhand einer spezifischen oder verschwommenen Absorption im sichtbaren Wellenlängenbereich äußern. Dadurch zeigt die Licht absorbierende Schicht allein durch den Sauerstoffmangel eine starke Absorption im sichtbaren Spektralbereich von 380-780 nm, jedoch nicht bis hinauf zu 1.500 nm, wie sie mit metallischen Schichtlagen erreichbar ist, und das, ohne dass dafür kristalline Partikel oder Ausscheidungen erforderlich sind.

So zeigen beispielsweise unterstöchiometrische Werkstoffe aus einer ZnO-Matrix und darin eingelagerten Bereichen aus unterstöchiometrischem Molybdänoxid eine ausgeprägte Absorption im sichtbaren Wellenlängenbereich.

Der Reduktionsgrad der Absorberschicht ist durch einen Sauerstoffgehalt von maximal 65 % des stöchiometrisch maximalen Sauerstoffgehalts definiert. Dabei ist anzumerken, dass der genannte Reduktionsgrad sich auf die Absorberschicht insgesamt bezieht, jedoch nicht ausschließlich der Basiskomponente K1 oder ausschließlich der Schwärzungskomponente K2 zugerechnet werden kann. Vielmehr ist zu erwarten, dass alle Komponenten der Schicht mehr oder weniger in reduziertem Zustand vorliegen. Der Reduktionsgrad der Absorberschicht wird aufgrund der Gewichtszunahme ermittelt, die sich ergibt, wenn der Schichtwerkstoff unter Inertgas pulverisiert wird (Partikelgröße < 10 $\mu$m) und das Pulver 1 Stunde lang unter reinem Sauerstoff bei 1000 °C geglüht wird. Der Reduktionsgrad R [%] bestimmt sich aus der Gewichtszunahme demnach wie folgt:

$$R \, [\%] = 100 \times \text{Gewichtszunahme} / \text{Gesamtgewicht an Sauerstoff der geglühten Probe.}$$

Der aus den Komponenten K1 und K2 bestehende Schichtwerkstoff wird im Folgenden auch als "Basiswerkstoff" bezeichnet. Der Mengenanteil der Schwärzungskomponente K2 (beispielsweise der Molybdän-Anteil) ergibt sich aus dem Anteil an unterstöchiometrischem Oxid/ Oxinitrid oder Metall innerhalb der Matrix, wobei der Anteil jeweils aus dem Gewicht bestimmt wird, der allein auf das elementare Metall der Komponente K2 entfällt, und das Metallgewicht in Beziehung zum Gewicht der Matrix gesetzt wird. Der so berechnete Metall-Gewichtsanteil der Schwärzungskomponente K2 liegt im Bereich zwischen 20 und 50 Gew.-%, bevorzugt beträgt er jedoch mindestens 25 Gew.-%, und er liegt idealerweise im Bereich zwischen 30 und 45 Gew.-%.

Der Basiswerkstoff aus K1 und K2 mit den oben erläuterten Anteilen ergibt eine Schicht mit folgenden Eigenschaften:

- Sie ist unter Einsatz verdünnter Säuren aus der Gruppe $HNO_3$, HCl, und organischen Säuren, wie Oxalsäure, Essigsäure, Phosphorsäure und auch mittels Ansätzen auf der Basis von $KOH+H_2O_2$ oder unter Zusatz von fluoridhaltigen Verbindungen wie beispielsweise $NH_4HF_2$, ohne Partikelbildung ätzbar. Flusssäure wird nicht benötigt.
- Bei einer Wellenlänge von 550 nm hat sie einen Absorptionsindex kappa von mehr als 0,7.

Für den Absorptionsindex kappa gilt hierbei:

$$n_*kappa=k,$$

mit k=Extinktionskoeffizient, der wiederum in die komplexe Brechzahl

$$N=n+i_*k$$

eingeht und mittels dem ein Dämpfungsbeitrag durch den Imaginärteil im Brechungsindex der Schicht berücksichtigt wird.

Die Ätzgeschwindigkeit des Basiswerkstoffs hängt von der Zusammensetzung ab. Unterstöchiometrische oder metallische Phasen der Komponente K2 neigen nicht dazu, schwer ätzbare Strukturen zu bilden. Die Ätzrate wird daher in erster Linie durch den Anteil der Basiskomponente K1 bestimmt. Zinkoxid, Zinnoxid und Indiumoxid sind jedoch relativ leicht ätzbare Oxide mit vergleichsweise hoher spezifischer Ätzrate.

Die Ätzgeschwindigkeit des Basiswerkstoffs kann durch einen teilweisen Ersatz des Sauerstoffs durch Stickstoff verringert werden, wobei dieser Effekt aber gering ist und allenfalls zur Feinabstimmung geeignet ist. Im Wesentlichen wird die Ätzgeschwindigkeit des Basiswerkstoffs nur innerhalb der von der Zusammensetzung und insbesondere dem Anteil an K1 gezogenen Grenzen variiert werden.

Insbesondere kann die Ätzgeschwindigkeit des Basiswerkstoffs kaum unter die von K1 in Kombination mit K2 vorgegebene spezifische Ätzrate verlangsamt werden. Bei besonders hohen Anforderungen an die Variabilität der Ätzgeschwindigkeit und insbesondere bei einer Soll- Ätzgeschwindigkeit, die geringer sein muss als die spezifische Ätzrate von K1 ist der Basiswerkstoff jedoch kaum geeignet.

Erfindungsgemäß wird das Ätzverhalten des reinen Basiswerkstoffs daher modifiziert, indem ein Teil der Basiskomponente K1 durch die Zusatzkomponente K3 ersetzt wird. Die Zusatzkomponente K3 liegt - wie die Basiskomponente K1 - als vollständig oxidiertes Metall (=Volloxid) oder als unterstöchiometrisches Oxid (mit Sauerstoffmangel) vor und ist ausgewählt aus der Gruppe bestehend aus Nioboxid, Hafniumoxid, Titanoxid, Tantaloxid, Vanadiumoxid, Yttriumoxid, Zirkonoxid und/oder Aluminiumoxid. Über Art, Zusammensetzung und Mengenanteil der Zusatzkomponente K3 kann das Ätzverhalten des Schichtwerkstoffs innerhalb von Grenzen eingestellt werden, die weiter sind als ohne die Zusatzkomponente K3. Durch den Zusatz kann die Ätzgeschwindigkeit des Schichtwerkstoffs in weiten Grenzen verlangsamt und feinjustiert werden.

Die oxidische Zusatzkomponente K3 ist schlechter, also langsamer ätzbar als die oxidische Basiskomponente K1. Die Zusatzkomponente K3 - wie etwa $Nb_2O_5$-ersetzt einen Teil der Basiskomponente (wie etwa ZnO), jedoch maximal 75 Gew.-% davon. Basiskomponente K1 und Zusatzkomponente K3 zusammen machen zwischen 50 Gew.-% und 80 Gew.-% des Schichtwerkstoffes aus. Die im Wesentlichen oxidische Matrix des Schichtwerkstoffs setzt sich in dem Fall aus der Basiskomponente K1 und der Zusatzkomponente K3 zusammen; darin verteilt ist die Schwärzungskomponente K2. Der Anteil der Zusatzkomponente K3 wird dabei berechnet als Gewichtsanteil der Zusatzkomponente K3 bezogen auf das Gesamtgewicht der volloxidischen Matrix.

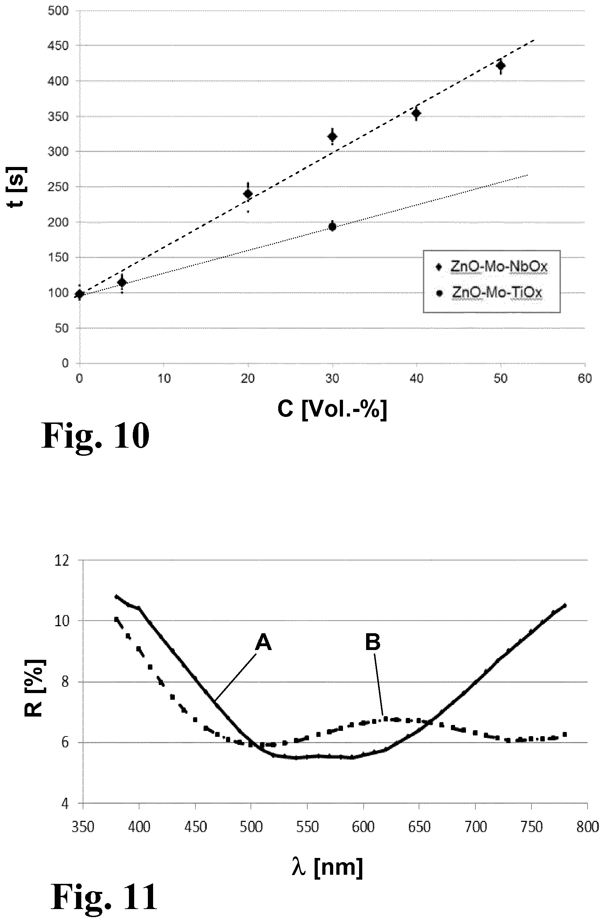

Basiswerkstoff und Zusatzkomponente K3 sind so aufeinander abgestimmt, dass die Zusatzkomponente K3 eine Verlangsamung der Ätzrate des Basiswerkstoffs bewirkt. Im Hinblick hierauf wurden Basiswerkstoffe mit Komponenten K3, deren Zusammensetzung insgesamt von der obigen Summenformel subsumierbar ist, in der Literatur bisher nicht beschrieben. Basierend auf dem Verständnis der Auswirkung der Zusatzkomponente K3 auf die Ätzgeschwindigkeit des Basiswerkstoffs, die etwa linear sein kann wie Figur 10 ergibt, ermöglicht die obige Summenformel eine Charakterisierung nicht voll oxidischer Schichtwerkstoffe ohne aufwändige experimentelle Untersuchungen, ohne dass ausgeschlossen ist, dass sich weitere geeignete Mischoxidsysteme mit Zusammensetzungen außerhalb dieser Summenformel finden.

Über die Zusatzkomponente K3 kann das Ätzverhalten der Licht absorbierenden Schicht (Absorberschicht) oder das Ätzverhalten eines die Absorberschicht enthaltenden Schichtsystems an die Ätzrate angrenzender Schichten angepasst werden, um beispielsweise ein Unterätzen von Schichten zu vermeiden. Je nach vorgegebener spezifischer Ätzrate des Schichtwerkstoffs liegt der Anteil y der der Zusatzkomponente K3 zwischen 0 und <15 Gew.-% (für relativ hohe Soll-Ätzraten), zwischen 15 und < 30 Gew.-% (für mittlere Soll-Ätzraten), zwischen 30 und < 45 Gew.-% (für relativ niedrige Soll-Ätzraten) oder zwischen 45 und 60 Gew.-% (für sehr niedrige Soll-Ätzraten).

Im Hinblick auf die optischen Eigenschaften des Schichtwerkstoffs und insbesondere im Hinblick auf einen möglichst hohen kappa-Wert und eine geringe Reflexion der Schicht hat es sich aber als besonders vorteilhaft erwiesen, wenn maximal ein Drittel der Basiskomponente durch die Zusatzkomponente K3 ersetzt ist.

Die oxidische oder vorwiegend oxidische Zusatzkomponente K3 ersetzt dabei einen Teil der oxidischen oder vorwiegend oxidischen Basiskomponente K1 und bildet mit diesem ein Mischoxidgefüge. In diesem sind Anteile von K2 homogen verteilt.

Im Zusammenhang mit einem möglichst homogenen Ätzverhalten ist es besonders vorteilhaft, wenn der Schichtwerkstoff eine (röntgenographisch) amorphe, homogene Struktur hat in dem Sinne, dass er keine mittels Röntgendiffraktometermessungen erfassbaren kristallinen Strukturen aufweist.

Hiermit ergibt sich ein homogenes Ätzverhalten, wie beispielsweise beim Ätzen mit Fluorid-Ionen oder Ansätzen auf der Basis von $KOH+H_2O_2$. Die so charakterisierten Schichten zeigen auch bei transelektronenmikroskopischer Betrachtung keine Strukturen bis hinunter zu der Auflösungsgrenze von 2 nm. Thermodynamisch ist die amorphe Struktur jedoch instabil, so dass sich durch Tempern oder Aufheizen kristalline Ausscheidungen bilden können.

Das erfindungsgemäße Schichtsystem

Die oben genannte Aufgabe wird hinsichtlich des Licht absorbierenden Schichtsystems erfindungsgemäß durch eine erste Ausführungsform gelöst, welche die Licht absorbierende Schicht gemäß der Erfindung als eine dem Betrachter abgewandte Absorberschicht in Verbindung mit einer dem Betrachter zugewandten Antireflexschicht umfasst, wobei das Schichtsystem im Wellenlängenbereich von 380 bis 780 nm durch eine visuelle Transmission Tv von weniger als 2 % und eine visuelle Reflexion Rv von weniger als 6 % gekennzeichnet ist.

Das Schichtsystem enthält mindestens eine Licht absorbierende Schicht, wie sie oben bereits erläutert ist und die hier auch als "Absorberschicht" bezeichnet wird, und mindestens eine Antireflexschicht. Diese wird im Folgenden noch näher erläutert.

Die Antireflexschicht kann auf einem Substrat aus lichtdurchlässigem Werkstoff aufgebracht sein, beispielsweise auf einer Glasplatte, einem Kunststoff-Träger oder einer Folie. Auf die Antireflexschicht folgt entweder unmittelbar oder über eine oder mehrere Zwischenschichten die erfindungsgemäße Absorberschicht, die mit weiteren funktionalen Schichten versehen sein kann.

Die Angaben zur visuellen Transmission Tv und zur visuellen Reflexion Rv beziehen sich hierbei auf das gesamte Schichtsystem. Als visuelle Transmission Tv wird dabei die auf Augenempfindlichkeit normierte Transmission verstanden, die aus der Gesamt-Transmission des Schichtsystems berechnet wird. Zur Berechnung der visuellen Transmission Tv werden die Messwerte eines Spektrometers mit den genormten Faktoren der Augenempfindlichkeit gefaltet und aufintegriert beziehungsweise summiert. Diese Faktoren der Augenempfindlichkeit sind in der DIN EN 410 festgelegt.

Analog dazu wird unter der visuellen Reflexion Rv die auf Augenempfindlichkeit normierte Reflexion verstanden, die aus der Gesamtreflexion des Schichtsystems berechnet wird. Wie für die visuelle Transmission bereits erläutert, werden in äquivalenter Weise auch zur Berechnung der visuellen Reflexion Rv die Messwerte des Spektrometers mit den genormten Faktoren der Augenempfindlichkeit gefaltet und aufintegriert beziehungsweise summiert, wobei die Faktoren der Augenempfindlichkeit in der DIN EN 410 festgelegt sind. Ist die Licht absorbierende Schicht auf einem transparenten Substrat aufgebracht, wird zur Berechnung der visuellen Reflexion noch der Reflexionswert an der nicht beschichteten Oberfläche des Substrates abgezogen. Die visuelle Reflexion Rv beträgt weniger als 6 % bevorzugt weniger als 3%.

Das Schichtsystem insgesamt soll für einen Betrachter optisch nicht transparent, also undurchsichtig erscheinen. Dies erfordert eine hohe Absorption im sichtbaren Spektralbereich von 380-780 nm. Zumindest in der vom Betrachter aus gesehen hinteren Schichtlage - also der Absorberschicht - ist daher eine geringe visuelle Transmission Tv zu gewährleisten, so dass sich für das Schichtsystem insgesamt eine geringe visuelle Transmission Tv im genannten Wellenlängenbereich von weniger als 2 %, vorzugsweise von weniger als 1 % und besonders bevorzugt von weniger als 0,2 % einstellt. Aus dem gleichen Grund ist auch eine geringe visuelle Reflexion Rv erwünscht, die bevorzugt bei weniger als 3 % liegt.

Für die Ausbildung der Antireflexschicht kommen grundsätzlich und bevorzugt dieselben Substanzen in Betracht wie für die Absorberschicht, jedoch dann mit voller Stöchiometrie oder allenfalls mit einem weniger ausgeprägten Sauerstoffmangel. Es hat sich sogar als vorteilhaft erwiesen, wenn auch die Antireflexschicht einen gewissen Sauerstoffmangel aufweist, wobei der Sauerstoffmangel aber geringer ist als in der Absorberschicht und der Sauerstoffgehalt mindestens 95 % des stöchiometrischen Sauerstoffgehalts beträgt. Dadurch erzeugt nicht nur die Absorberschicht, sondern auch die Antireflexschicht eine gewisse Absorption, so dass die Gesamtdicke des Schichtsystems zur Gewährleistung der erforderlichen Gesamt-Absorption geringer gehalten werden kann.

Es sind aber auch andere, in der Literatur zur Antireflexbeschichtung eingesetzte dielektrische Schichtsysteme geeignet, beispielsweise AlN, $SnO_2$, $Si_3N_4$, $HfO_2$, ZnO, $TiO_2$, $HfO_2$, $Al_2O_3$, Siliciumoxinitrid oder deren Mischungen.

Die Funktion der Antireflexschicht, nämlich die Reflexion des einfallenden Lichts im sichtbaren Wellenlängenbereich möglichst gering zu halten, wird vorteilhafterweise dadurch erfüllt, dass sie auf einem Substrat aufgebracht ist und einen Brechungsindex $n_R$ hat, für den gilt: $n_s < n_R < n_A$, wobei $n_s$ der Brechungsindex des Substrats und $n_A$ der Brechungsindex der Absorberschicht sind. Es sind aber auch Lösungen darstellbar, bei denen die Schicht oder das Schichtsystem z.B. gegen Luft eingestellt wird.

Obwohl es technisch einfacher ist, eine Doppelschicht aus Antireflexschicht und Absorberschicht auszuführen, ist auch ein Aufbau des Schichtsystems aus mehreren, in ihrer Sauerstoff-Unterstöchiometrie abgestuften Schichten oder auch eine Gradientenschicht möglich, die in Blickrichtung des Betrachters aus gesehen kontinuierlich sauerstoffärmer wird.

Wesentliche Funktion der Absorberschicht ist die Erzeugung einer möglichst hohen Absorption der über die Antireflexschicht einfallenden optischen Strahlung. Parameter zur Erfüllung dieser Funktion sind außer dem Werkstoff der Absorberschicht ihre Schichtdicke und der Grad des Sauerstoffmangels.

Im Hinblick auf die Herstellkosten ist die Gesamtdicke des Schichtsystems so klein wie möglich, um eine vorgegebene maximale Transmission einzuhalten. Wesentliche Parameter sind dabei der Sauerstoffmangel und die Dicke der Absorberschicht. Die erforderliche Mindestdicke kann durch Versuche einfach ermittelt werden. Als geeigneter Kompromiss zwischen hoher Absorption des Schichtsystems einerseits und Beschichtungskosten andererseits hat sich ein Schichtaufbau erwiesen, bei dem die Licht absorbierende Schicht eine Schichtdicke von weniger als 600 nm hat und vorzugsweise im Bereich von 250 bis 450 nm liegt.

Im Sinne einer möglichst geringen Reflexion in Gegenrichtung zum einfallenden Licht und einer guten Reflexionsanpassung an die Absorberschicht hat die Antireflexschicht vorzugsweise eine Dicke im Bereich von 45 bis 60 nm.

Mit zunehmendem Gehalt an unterstöchiometrischer zweiter Komponente, beispielsweise mit zunehmendem Gehalt an unterstöchiometrischem Molybdänoxid - das heißt, mit steigendem Sauerstoffmangel - nimmt der Brechungsindex der jeweiligen Schicht zu und damit die Schwierigkeit einer ausreicheichenden Entspiegelung. Ein optimaler Kompromiss zwischen möglichst hoher optischer Absorption einerseits und guter Entspiegelung andererseits ergibt sich, wenn der Sauerstoffgehalt der Absorberschicht zwischen 30 und 65 %, vorzugsweise zwischen 40 und 60 % des stöchiometrischen Sauerstoffgehalts der volloxidischen Schicht beträgt. Der Absorberschicht fehlen dabei also zwischen 30 und 65 %, vorzugsweise zwischen 40 und 60 % der Sauerstoffatome, die in einer voll stöchiometrischen, dielektrischen Schicht anzutreffen wären.

Die oben genannte Aufgabe wird erfindungsgemäß auch durch eine weitere Ausführungsform des Licht absorbierenden Schichtsystems gelöst, welche die Licht absorbierende Schicht gemäß der Erfindung als eine einem Betrachter zugewandte Absorberschicht in Verbindung mit einer dem Betrachter abgewandten und als Leiterbahn dienenden metallischen Schicht umfasst.

Bei dieser Ausführungsform des Schichtsystems ist die oben bereits erörterte Licht absorbierende Schicht (Absorberschicht) unmittelbar oder mittelbar auf einer metallischen Schicht aufgebracht und verdeckt diese somit für einen Betrachter, dem die Absorberschicht zugewandt ist. Die Absorberschicht ist beispielsweise auf elektronischen Bauteilen und Leitungen aufgebracht, um diese abzudecken und für den Betrachter unsichtbar zu machen. Die Absorberschicht selbst kann gegen Luft oder ein anderes optisch dichteres, aber transparentes Medium arbeiten, wie beispielsweise Glas oder Kunststoff.

Die metallische Schicht enthält vorzugsweise eines oder mehrere der Metalle, ausgewählt aus der Gruppe: Al, Mo, Cu, Ti.

Die metallische Schicht dient als Leiterbahn, so dass sich eine gute elektrische Leitfähigkeit ergibt. Aber auch andere Eigenschaften, insbesondere die Ätzbarkeit spielen eine wichtige Rolle. Die metallische Schicht besteht aus dem reinen Metall, einer Legierung der genannten Metalle untereinander oder aus einer Legierung auf Basis eines der genannten Metalle.

An die Lichtabsorption der Absorberschicht werden bei dieser Ausführungsform geringere Anforderungen gestellt als bei dem weiter oben erläuterten Schichtsystem aus Absorberschicht und Antireflexschicht. Denn die metallische Schicht trägt zur Absorption bei und der gesamte Schichtstapel aus metallischer Schicht und Absorberschicht muss nur insgesamt hochabsorbierend sein. Für die Absorberschicht genügt es in diesem Fall und es ist sogar vorteilhaft, wenn sie nur teilabsorbierend ist und damit teilweise auch antireflektierend wirkt.

Im Gegenzug kann die Schichtdicke der Absorberschicht geringer ausfallen, was zu geringeren Herstellkosten führt. Im Hinblick darauf hat es sich bewährt, wenn bei dieser Ausführungsform des Licht absorbierenden Schichtsystems die Kombination aus metallischer Schicht und Absorberschicht im Wellenlängenbereich von 380 bis 780 nm eine visuelle Transmission Tv weniger als 8 %, vorzugsweise weniger als 4 % und eine visuelle Reflexion Rv von weniger als 15 %, sowie eine Gesamtdicke von weniger als 90 nm, bevorzugt weniger als 60 nm aufweist.

Andererseits kann es sogar erwünscht sein, dass die Absorberschicht zur elektrischen Leitung beiträgt. Im Hinblick darauf zeichnet sich das Schichtsystem durch einen Schichtwiderstand von weniger als 100 Ohm/square aus.

Je nach Art des Metalls der metallischen Schicht haben sich unterschiedliche Abmessungen als günstig erwiesen.

Bei einer Ausführungsform des Schichtsystems, bei dem die metallische Schicht aus Aluminium oder einer Aluminium-Basislegierung besteht, hat diese vorzugsweise eine Dicke im Bereich von 17 bis 21 nm, wobei die Dicke der Absorberschicht im Bereich von 30 bis 50nm liegt und bevorzugt maximal 40 nm beträgt.

Bei einer anderen Ausführungsform des Licht absorbierenden Schichtsystems, bei dem die metallische Schicht aus Molybdän oder aus einer Molybdän-Basislegierung besteht, hat die metallische Schicht bevorzugt eine Dicke im Bereich von 15 bis 50 nm, besonders bevorzugt im Bereich von 25 bis 35 nm, wobei die Dicke der Absorberschicht im Bereich von 35 bis 50 nm liegt und bevorzugt maximal 40 nm beträgt.

Bei einer weiteren vorteilhaften Ausführungsform des Licht absorbierenden Schichtsystem besteht die metallische Schicht aus Kupfer oder einer Kupfer-Basislegierung und hat eine Dicke im Bereich von 40 bis 50 nm, wobei die Dicke der Absorberschicht im Bereich von 28 bis 50 nm liegt und bevorzugt maximal 40 nm beträgt.

Das erfindungsgemäße Sputtertarget

Die oben genannte Aufgabe wird hinsichtlich des Sputtertargets insbesondere zur Herstellung einer Licht absorbierenden Schicht oder eines Licht absorbierenden Schichtsystems gemäß der Erfindung dadurch gelöst, dass es aus einem Targetwerkstoff besteht, basierend auf

- mit einer oxidischen Matrix, basierend auf einer Basiskomponente K1, ausgewählt aus der Gruppe bestehend aus Zinkoxid, Zinnoxid und/oder Indiumoxid, und auf einer Zusatzkomponente K3, die die Basiskomponente K1 zu einem Anteil "y" zwischen 0 und 75 Gew.-% ersetzt und die ausgewählt ist aus der Gruppe bestehend aus Nioboxid, Hafniumoxid, Titanoxid, Tantaloxid, Vanadiumoxid, Yttriumoxid, Zirkonoxid, Aluminiumoxid und Mischungen davon,
- wobei in der Matrix eine Schwärzungskomponente K2 verteilt ist, ausgewählt aus der Gruppe bestehend aus Molybdän, Wolfram und Legierungen und Mischungen davon, wobei die Schwärzungskomponente K2 entweder als Metall und/oder als unterstöchiometrisch-oxidische oder unterstöchiometrisch-oxinitridische Verbindung des Metalls vorliegt und dabei einen Reduktionsgrad aufweist, der der durch einen Sauerstoffgehalt von maximal 65 % des stöchiometrisch maximalen Sauerstoffgehalts definiert ist, und wobei der Anteil "x" der Schwärzungskomponente K2 - berechnet aus dem Gewicht ihres Metall-Anteils bezogen auf das Gewicht des Targetwerkstoffs im Bereich zwischen 20 und 50 Gew.-% liegt.

Der Target-Basiswerkstoff des erfindungsgemäßen Sputtertargets unterscheidet sich vom Basiswerkstoff der Absorberschicht. Er enthält in der Regel kristalline Phasen in metallischer oder oxidischer Form und besteht aus einer vollständig oder überwiegend oxidischen Phase, die von einer oder mehreren Oxiden der Basiskomponente K1 gebildet wird, und aus einer stark unterstöchiometrischen oder metallischen Phase der Schwärzungskomponente K2, wie beispielsweise aus unterstöchiometrischem Molybdänoxid und/oder Molybdänmetall.

Der Anteil an der Schwärzungskomponente K2 in oxidischer und/oder metallischer Form berechnet sich aus dem Gewicht, der allein auf das elementare Metall der Verbindung K2 entfällt, wobei das Metallgewicht in Beziehung zum Gewicht zum Targetwerkstoff insgesamt gesetzt wird. Der so berechnete Gewichtsanteil der Schwärzungskomponente K2 liegt im Bereich zwischen 20 und 50 Gew.-%, bevorzugt beträgt er jedoch mindestens 25 Gew.-%, und er liegt idealerweise im Bereich zwischen 30 und 45 Gew.-%.

Die Zusammensetzung des Target-Basiswerkstoffs entspricht im Wesentlichen derjenigen des Basiswerkstoffs der Licht absorbierenden Schicht gemäß vorliegender Erfindung, insbesondere was den Sauerstoffgehalt und/oder Stickstoffgehalt anbelangt. Dies hat den Vorteil, dass die Licht absorbierende Schicht unter Einsatz des Sputtertargets ohne oder nur mit einem geringen Zusatz von Reaktivgas erzeugt werden kann. Im Gegensatz zum Sputtern von vollständig metallischen Targets sind damit auch bei MF- oder DC-Sputtern eine höhere Prozessstabilität und eine einfachere Prozessführung möglich. Denn insbesondere bei großflächigen Beschichtungen stößt das Reaktivsputtern ansonsten leicht an technologische Machbarkeitsgrenzen.

Die Randbedingungen hinsichtlich Eigenschaft und Herstellung der Licht absorbierenden Schicht sind erfüllbar, wenn sie durch MF- oder DC-Sputtern eines derartigen Sputtertargets erzeugt wird. Dieses weist einen Sauerstoffmangel auf, der entweder durch eine reduzierte Oxid oder Oxinitridphase von unterstöchiometrischem und dadurch elektrisch leitfähigem Metalloxid der Schwärzungskomponente K2 oder durch eine metallische Beimischung der Schwärzungskomponente zu dem Oxid der Basiskomponente K1 eingestellt wird. Die letztgenannte Ausführungsform ist in der Regel zu bevorzugen, da stark unterstöchiometrische Oxide schwer darstellbar sind.

Legierungen auf Basis der Schwärzungskomponente Mo und/oder W, die Zuschläge in Form von Elementen der CAS-Gruppen IVb, Vb und VIb enthalten (Ti, V, Cr, Zr, Nb, Hf, Ta) zeigen optische Eigenschaften, die denen der reinen Metalle W und Mo beziehungsweise deren Mischungen ähnlich sind.

Als Beispiele für den Basiswerkstoff seien ZnO+ $MoO_{2-w}$ ($0<w\leq2$) genannt, wobei $MoO_{2-w}$ ein unterstöchiometrisches Oxid oder Oxinitrid von Molybdän oder metallisches Molybdän (für $w=2$) repräsentiert. Dabei besteht der Target-Basiswerkstoff aus einer ersten Phase, basierend auf Zinkoxid, in der eine zweite Phase aus Molybdänoxid mit unterstöchiometrischem Gehalt an Sauerstoff oder aus Molybdänoxid mit unterstöchiometrischem Gehalt an Sauerstoff und metallischem Molybdän oder aus ausschließlich metallischem Molybdän eingelagert ist.

Das Ätzverhalten einer aus dem Basis-Targetwerkstoff erzeugten Sputterschicht wird in erster Linie vom Anteil der Basiskomponente K1 und der Schwärzungskomponente K2 bestimmt, also Komponenten, die vergleichsweise leicht ätzbar sind. Die Ätzgeschwindigkeit des Basiswerkstoffs kann daher in erster Näherung nur innerhalb der von der Zusammensetzung und dem Anteil an erster Komponente K1 gezogenen Grenzen variiert werden und erweist sich häufig als zu schnell.

Darüber hinaus kann die Ätzgeschwindigkeit des Basis-Targetwerkstoffs durch einen teilweisen Ersatz des Sauerstoffs durch Stickstoff verringert werden. Die dadurch erzielbare Verringerung der Ätzgeschwindigkeit ist aber begrenzt, so dass der Target-Basiswerkstoff besonders hohen Anforderungen an die Variabilität der Ätzgeschwindigkeit nicht genügt.

Optional enthält der Basiswerkstoff des Sputtertargets eine Zusatzkomponente K3, um das Ätzverhalten der daraus erzeugten Schicht in nennenswertem Umfang modifizieren zu können. Dabei wird ein Teil der Basiskomponente K1 durch eine zusätzliche Zusatzkomponente K3 ersetzt. Die Zusatzkomponente K3 liegt als Oxid eines metallischen Elements vor und ist ausgewählt aus der Gruppe bestehend aus Nioboxid, Hafniumoxid, Titanoxid, Tantaloxid, Vanadiumoxid und/oder Aluminiumoxid. Durch die Zusatzkomponente K3 kann die Ätzrate des Targetwerkstoffs innerhalb von Grenzen eingestellt werden, die weiter sind als ohne die Zusatzkomponente K3. Über Art, Zusammensetzung und Mengenanteil der Zusatzkomponente K3 wird somit das Ätzverhalten des Targetwerkstoffs verändert und feinjustiert.

Die Zusatzkomponente K3 umfasst ein Oxid oder mehrere Oxide aus der oben definierten Gruppe, das schlechter, also langsamer ätzbar ist als die oxidische Basiskomponente K1. Zur Einstellung der Ätzrate des Basiswerkstoffs ersetzt die Zusatzkomponente K3 - wie etwa $Nb_2O_5$ - einen Teil der Basiskomponente (wie etwa ZnO), jedoch maximal 75 Gew.-% davon. Der Anteil der Zusatzkomponente K3 wird dabei berechnet als Gewichtsanteil der der Zusatzkomponente zuzurechnenden Oxide am Gesamtgewicht des Targetwerkstoffs.

Je nach vorgegebener spezifischer Ätzrate des herzustellenden Schichtwerkstoffs liegt der Anteil der Zusatzkomponente K3 zwischen 0 und <15 Gew.-%, zwischen 15 und <30 Gew.-%, zwischen 30 und < 45 Gew.-% oder zwischen 45 und 60 Gew.-%. Im Hinblick auf die optischen Eigenschaften des herzustellenden Schichtwerkstoffs und insbesondere im Hinblick auf einen möglichst hohen kappa-Wert hat es sich aber als besonders vorteilhaft erwiesen, wenn maximal ein Drittel der Basiskomponente durch Zusatzkomponente K3 ersetzt ist.

Vorzugsweise liegt die Komponente K2 in metallischer Form vor.

Die metallische Form der Komponente kann technisch einfacher und besser reproduzierbar bereitgestellt werden als eine stark unterstöchiometrische Form. Die duktile Phase des Targetwerkstoffs bewirkt eine höhere Dichte, vermindert mechanische Spannungen und trägt zu einer höheren Festigkeit bei. Dabei hat es sich bewährt, wenn die metallische Schwärzungskomponente mindestens 50%, vorzugsweise mindestens 70% zur Einstellung der Unterstöchiometrie des Sputtertargets beiträgt.

Demgegenüber liegt die Zusatzkomponente K3 vorteilhafterweise als Oxid vor.

Die Metallanteile beziehungsweise unterstöchiometrischen Oxide des Sputtertargets bilden elektrisch leitende Phasen, so dass es mittels DC- oder MF-Sputtern verarbeitet werden kann. Zu diesem Zweck beträgt sein spezifischer elektrischer Widerstand vorzugsweise weniger als 10 Ohm*cm und besonders bevorzugt weniger als 1 Ohm*cm.

Im erfindungsgemäßen Sputtertarget ist der Sauerstoffmangel der erfindungsgemäßen Licht absorbierenden Schicht beziehungsweise des Schichtsystems im Wesentlichen bereits angelegt, indem der Sauerstoffmangel des Sputtertargets dem der jeweilig zu sputternden Schicht in etwa entspricht oder ihn etwas übersteigt. Eine Feinjustierung der Schichtstöchiometrie kann durch geringe Zugaben an Reaktivgasen (insbesondere von Sauerstoff) erreicht werden, so dass die erwähnten technologischen Schwierigkeiten beim Absputtern von Metalltargets unter hochreaktiver Atmosphäre vermieden werden. Neben Sauerstoff ist auch die Zugabe anderer reaktiver Gase wie Stickstoff geeignet.

Der Sauerstoffmangel des Sputtertargets ist vorzugsweise durch einen Reduktionsgrad definiert, bei dem der Sauerstoffgehalt zwischen 30 und 65 %, vorzugsweise zwischen 40 und 60 % % des stöchiometrischen Sauerstoffgehalts liegt. Beim Sputtern wird ein vorgegebener Sauerstoff-Unterschuss in der abgeschiedenen Schicht eingestellt. Der Anteil an Schwärzungskomponente K2 im Targetwerkstoff ist so ausgelegt, dass er 50 % oder mehr dieses Unterschusses ausmacht.

Es hat sich als vorteilhaft erwiesen, wenn der Reduktionsgrad über die Dicke des Sputtertargets möglichst gleichbleibend ist. Daher weist das unterstöchiometrische Sputtertarget bevorzugt einen Reduktionsgrad auf, der an mindestens 5 Stellen über die Dicke des Sputtertargets gemessen um nicht mehr als +-5 % (relativ) um einen Mittelwert streut.

Der Reduktionsgrad wird im einfachsten Fall bestimmt, indem mindestens fünf Proben mit einem Gewicht von 1 g aus unterschiedlichen Dickenbereichen der Targetschicht genommen und an diesen Proben die Gewichtszunahme ermittelt wird, die sich ergibt, wenn der Targetwerkstoff unter Inertgas pulverisiert wird (Partikelgröße < 10 $\mu$m) und das Pulver 1 Stunde lang unter reinem Sauerstoff bei 1000 °C geglüht wird. Der Reduktionsgrad R [%] bestimmt sich aus der Gewichtszunahme demnach wie folgt:

$$R\ [\%] = 100 \times \text{Gewichtszunahme} / \text{Gesamtgewicht an Sauerstoff der geglühten Probe.}$$

Ergänzend dazu kann der Reduktionsgrad verifiziert werden, indem mindestens fünf Proben mit einem Gewicht von 1 g aus unterschiedlichen Dickenbereichen der Targetschicht genommen werden, und an diesen Proben der Sauerstoffgehalt über die Umsetzung zu CO und eine Trägergasextraktion bestimmt wird. Der homogene Reduktionsgrad trägt zu einer hohen Prozessstabilität beim Sputterprozess und zur Erzeugung von Sputterschichten mit reproduzierbaren Eigenschaften bei.

Im Hinblick hierauf hat es sich auch bewährt, wenn die etwaige metallische Schwärzungskomponente als Beimischung einen Metallgehalt definiert, der an mindestens 5 Stellen über die Dicke des Sputtertargets gemessen um nicht mehr als +-5 % (relativ) um einen Mittelwert streut.

Im Hinblick auf ein gleichmäßiges Absputtern des Sputtertargets hat der Targetwerkstoff vorzugsweise eine Dichte von mehr als 95 % der theoretischen Dichte und einen Gehalt an Verunreinigungen von weniger als 500 Gew.-ppm.

Als Verunreinigungen werden dabei alle Elemente aufgefasst, die nicht absichtlich als Dotierstoffe oder Zusätze dem Targetwerkstoff hinzugefügt sind.

Der Reduktionsgrad des Targetwerkstoffs ist vorzugsweise durch einen Sauerstoffgehalt zwischen 30 und 65 %, vorzugsweise zwischen 40 und 50 % des theoretisch maximal möglichen Sauerstoffgehalts definiert.

Er wird durch Glühen des pulverisierten Targetmaterials bei 1000°C bestimmt, wie weiter oben für die Absorberschicht bereits erläutert. Der Reduktionsgrad R [%] bestimmt sich aus der Gewichtszunahme wie folgt:

$$R\ [\%] = 100 \times \text{Gewichtszunahme} / \text{Gesamtgewicht an Sauerstoff der geglühten Probe.}$$

Das erfindungsgemäße Herstellungsverfahren für die Licht absorbierende Schicht

Die oben genannte Aufgabe wird hinsichtlich des Verfahrens zur Herstellung der Licht absorbierenden Schicht oder des Licht absorbierenden Schichtsystems durch DC- oder MF-Sputtern eines Sputtertargets erfindungsgemäß dadurch gelöst, dass das Sputtern in einer Sputter-Atmosphäre erfolgt, die ein Edelgas und ein Reaktivgas in Form von Sauerstoff und/oder Stickstoff enthält, wobei der Reaktivgasgehalt in der Sputter-Atmosphäre auf maximal 10 Vol.-%, bevorzugt auf maximal 4 Vol.-% eingestellt wird.

Das erfindungsgemäße Verfahren zeichnet sich durch das Zusammenspiel einer nur wenig reaktiven Sputter-Atmosphäre einerseits und andererseits durch einen Einsatz eines Sputtertargets aus, das ein Oxid der Basiskomponente K1 sowie eine unterstöchiometrische Schwärzungskomponente K2 (wie etwa Molybdän-Oxid oder Molybdän-Metall) enthält. Die abgeschiedene (Absorber)Schicht unterscheidet sich in ihrer chemischen Zusammensetzung nicht wesentlich von der des eingesetzten Target-Materials. Dies erlaubt eine stabile Führung des Sputterprozesses und die reproduzierbare Einstellung der Eigenschaften der abgeschiedenen Schicht.

Dazu trägt auch eine besonders bevorzugte Modifikation dieser Verfahrensweise bei, bei der - jeweils bezogen auf ideale, vollständige Stöchiometrie - der Anteil an Sauerstoff im Material des Sputtertargets gleich groß oder nur wenig kleiner ist als der Anteil an Sauerstoff der Licht absorbierenden Schicht, wobei der SauerstoffAnteil im Material des Sputtertargets jedoch mindestens 50 %, bevorzugt mindestens 70 % des Sauerstoff-Anteils in der Absorberschicht ausmacht.

Dadurch ist das Targetmaterial unverändert oder mit nur geringer Aufoxidation in das unterstöchiometrische Oxid der Licht absorbierenden Schicht übertragbar. Dabei ist zu beachten, dass üblicherweise beim Sputterprozess ein gewisser Sauerstoffverlust beobachtet wird, der auch einen kleinen Beitrag zur Einstellung der gewünschten Unterstöchiometrie der Licht absorbierenden Schicht liefern kann.

Bei einer besonders einfachen Verfahrensweise wird zur Abscheidung einer Antireflexschicht und zur Abscheidung einer Absorberschicht ein Sputtertarget mit nominal gleicher Zusammensetzung eingesetzt, wobei die Sputter-Atmosphäre bei der Abscheidung der Antireflexschicht einen höheren Reaktivgasgehalt hat als bei der Abscheidung der Absorberschicht, derart, dass sich in der Antireflexschicht ein Sauerstoffunterschuss einstellt, der - bezogen auf das Gewicht an Sauerstoff einer stöchiometrischen Schicht - weniger als 5% beträgt.

Die höhere Reaktivgaszugabe bei der Abscheidung der Antireflexschicht ist dabei so zu wählen, so dass die Antireflexschicht ausreichend dielektrisch wird.

Ausführungsbeispiel

Nachfolgend wird die Erfindung anhand einer Patentzeichnung und eines Ausführungsbeispiels näher erläutert. Im Einzelnen zeigt:

**Figur 1** eine schematische Darstellung des erfindungsgemäßen Schichtsystems in einem Querschnitt,
**Figur 2** eine elektronenmikroskopische Aufnahme eines Schliffs des Schichtsystems aus Figur 1
**Figur 3** eine TEM-Aufnahme des Schliffs aus Figur 2 in maximaler Vergrößerung
**Figur 4** den spektralen Verlauf der Transmission einer ersten Ausführungsform des erfindungsgemäßen Schichtsystems,
**Figur 5** den spektralen Verlauf der Reflexion derselben Ausführungsform,
**Figur 6** einen Vergleich der Reflexionsverläufe von erster Ausführungsform und einer zweiten Ausführungsform des Schichtsystems,
**Figur 7** einen Vergleich der Reflexionsverläufe von erster Ausführungsform und einer dritten Ausführungsform des erfindungsgemäßen Schichtsystems,
**Figur 8** Transmissions- und Reflexionskurven einer weiteren Ausführungsform des erfindungsgemäßen Schichtsystems,
**Figur 9** ein Röntgenbeugungsdiagramme der erfindungsgemäßen Schicht,
**Figur 10** ein Diagramm zum Ätzverhalten verschiedener Targetwerkstoffe gemäß der Erfindung,
**Figur 11** Reflexionskurven für zwei Schichtsystem auf Basis von $ZnO+Mo+Nb_2O_5$,
**Figur 12** Reflexionskurven einer einlagigen Absorberschicht gemäß der Erfindung, und
**Figur 13** Transmissionskurven einer einlagigen Absorberschicht gemäß der Erfindung.

Beispiel 1: Schichtsysteme aus Antireflex- und Absorberschicht

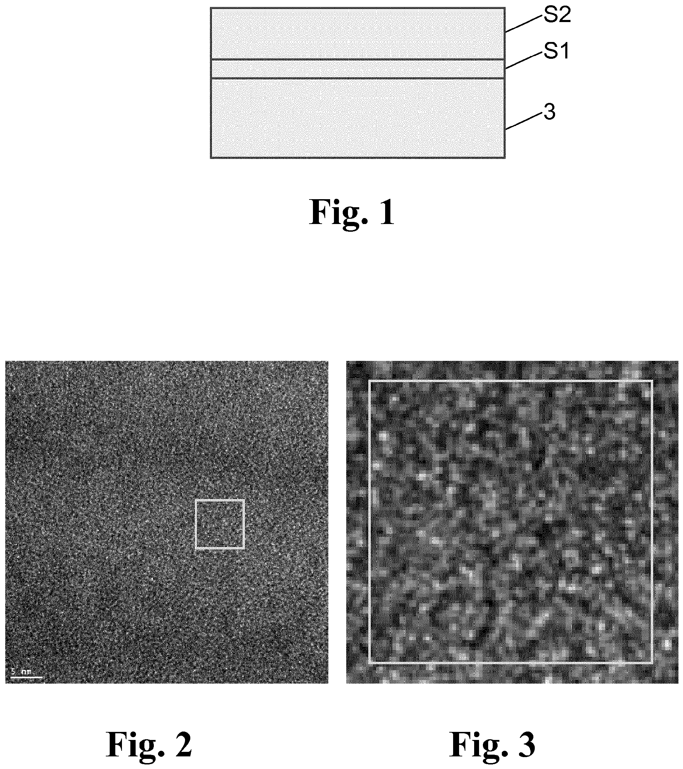

**Figur 1** zeigt schematisch ein aus zwei Schichten S1, S2 bestehendes Schichtsystem 1 gemäß der Erfindung. Die erste Schicht ist eine auf einer transparenten Glasplatte 3 aufgebrachte Antireflexschicht S1, und die zweite Schicht ist eine auf der Antireflexschicht S1 erzeugte Absorberschicht S2. Die Schichtdicke der Antireflexschicht S1 beträgt etwa 49 nm und die Schichtdicke der Absorberschicht S2 beträgt etwa 424 nm (entsprechend Probe 1 von Tabelle 1).

Die Schichten S1 und S2 bestehen jeweils aus einer Zink- und Molybdänoxidschicht mit unterschiedlichem Sauerstoffmangel. Der Sauerstoffgehalt der Antireflexschicht S1 liegt bei 95% des stöchiometrischen Sauerstoffgehalts. Der Sauerstoffgehalt der Absorberschicht S2 ist geringer und liegt im Bereich von 35 bis 70 % des stöchiometrischen Sauerstoffgehalts. Das Schichtsystem ist für einen Betrachter mit Blickrichtung von der Glasplatte 3 aus nahezu undurchsichtig und zugleich fast schwarz.

Der Sauerstoffgehalt der Schichten wird mittels EPMA-Messungen (Electron Probe Microscope Analysis) ermittelt. Dabei wird ein Elektronenstrahl auf die Probe gerichtet und die dabei erzeugte Röntgenstrahlung analysiert. Es kann gegen Standards kalibriert werden, so dass der relative Messfehler etwa bei 3-4%, liegt und der Sauerstoffgehalt der unterstöchiometrischen Schicht auf etwa +-3-4 Atom-% bestimmt werden kann. Um keine Messfehler durch das Substrat zu erhalten, sind hierfür am besten Schichten mit $>1\mu m$ Dicke herzustellen.

**Figur 2** zeigt eine elektronenmikroskopische Aufnahme eines Schliffs dieses Werkstoffs. Auch in der TEM-Aufnahme von **Figur 3** mit maximaler Auflösung sind keine Metallausscheidungen zu erkennen.

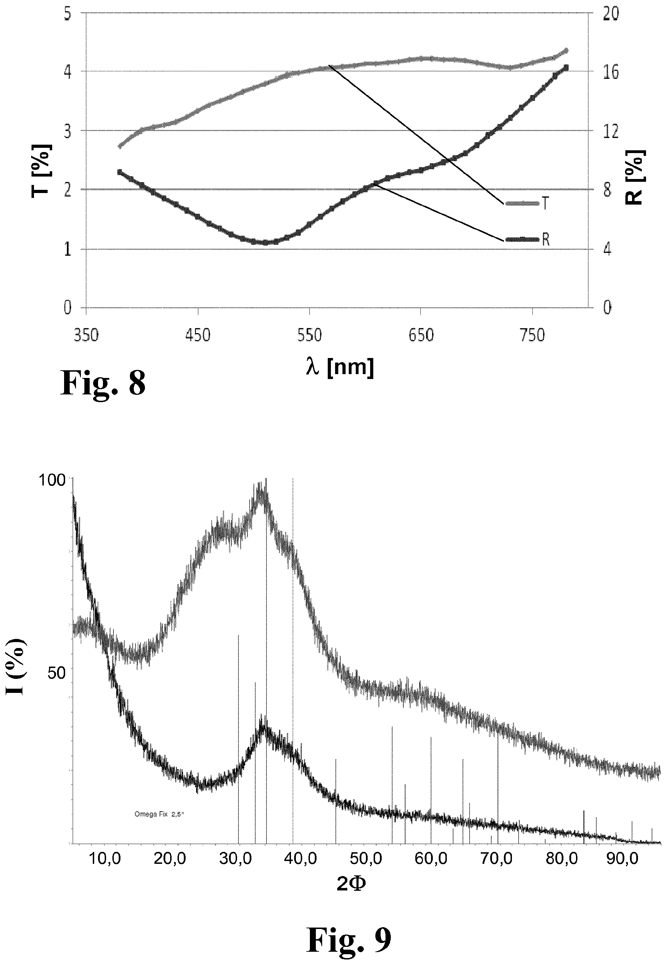

Dieses Ergebnis wird bestätigt durch das Röntgenbeugungsdiagramm der Schichtwerkstoffe in **Figur 9,** das die Streuintensität I über dem Beugungswinkel $2\Phi$ zeigt. Es sind keine konkreten Beugungslinien zu erkennen; beide Schichten des Schichtsystems sind röntgenamorph.

Aus **Tabelle 1** ergeben sich die jeweiligen Metallgehalte des zur Herstellung eingesetzten Sputtertargets und Schichtdicken d der Schichten S1 und S2 für das Schichtsystem auf Basis von unterstöchiometrischen Zink und Molybdän-Oxid. Die Angaben zum Molybdängehalt beziehen sich auf den Gewichtsanteil an metallischem Molybdän im Sputtertarget bezogen auf die Matrix aus Zinkoxid. Außerdem sind Messwerte für die Transmission $T_V$, die Reflexion $R_V$ (abzüglich 4 % für die Reflexion an der Vorderseite des unbeschichteten Glassubstrats), den Absorptionskoeffizient Kappa der hergestellten Schichtstruktur und den elektrischen Schichtwiderstandes RY angegeben.

**Tabelle 1 (Beispiele ZnO+Mo)**

| Nr. | Matrix | S1 Mo [Gew%] | S1 d [nm] | S2 Mo [Gew%] | S2 d [nm] | Rv [%] | Tv [%] | kappa @ 550nm | RΥ [Ohm] |
|-----|--------|--------------|-----------|--------------|-----------|--------|--------|---------------|----------|
| 1 | ZnO | 31,4 | 49 | 31,4 | 424 | 0,8 | 0,1 | 0,737 | 555 |
| 2 | ZnO | 37,9 | 50 | 31,4 | 423 | 0,9 | 0,1 | 0,737 | 550 |

(fortgesetzt)

| Nr. | Matrix | S1 Mo [Gew%] | S1 d [nm] | S2 Mo [Gew%] | S2 d [nm] | Rv [%] | Tv [%] | kappa @ 550nm | Rϒ [Ohm] |
|---|---|---|---|---|---|---|---|---|---|
| 3 | ZnO | 37,9 | 55 | 37,9 | 307 | 2,3 | 0,1 | 0,977 | 725 |
| 4 | ZnO | 31,4 | 55 | 37,9 | 308 | 2,2 | 0,1 | 0,977 | 720 |
| 5 | ZnO | 31,4 | 48 | 31,4 | 252 | 1,3 | 1,4 | 0,737 | 924 |
| 6 | ZnO | 37,9 | 49 | 31,4 | 252 | 1,4 | 1,4 | 0,737 | 920 |
| 7 | ZnO | 37,9 | 56 | 37,9 | 322 | 2,2 | 0,08 | 0,977 | 650 |

Tabelle 1 zeigt, dass bei der Antireflexschicht S1 der Mo-Gehalt keinen merklichen Einfluss auf die Reflexion hat. Demgegenüber sinkt bei der Absorberschicht die Reflexion mit sinkendem Mo-Gehalt, wohingegen die Transmission mit sinkendem Mo-Gehalt zunimmt.

Nachfolgend wird ein Verfahren zur Herstellung des erfindungsgemäßen Schichtsystems anhand eines Beispiels näher erläutert:

Targetherstellung - Verfahrensweise 1

Eine Pulvermischung aus 68,6 Gew.-% ZnO (mittlere Korngröße < 5 $\mu$m) und 31,4 Gew.-% Mo mit einer mittleren Korngröße von 25 $\mu$m wird in einem Taumel-Mischer 1h lang intensiv gemischt, so dass sich eine feine und monodisperse Verteilung der Mo-Partikel in ZnO ergibt. Anschließend wird diese Mischung in eine Graphitform mit einem Durchmesser von 75 mm und einer Höhe von 15 mm gefüllt. Die Ronde wird durch Heißpressen 1150°C und 30 MPa zu 85 % der theoretischen Dichte verdichtet. Das so erhaltene Gefüge besteht aus einer ZnO-Matrix, in die Mo-Partikel mit einer mittleren Korngröße von 25 $\mu$m eingebettet sind.

Targetherstellung - Verfahrensweise 2

Ein zweites Sputtertarget mit 62,1 Gew.-% ZnO und 37,9 Gew.-% Mo hergestellt, wobei zur Herstellung einer besonders gleichmäßigen Mo-Verteilung ein Mo-Pulver mit <10 $\mu$m Korngröße gewählt. Nach dem Mischen wird das Pulver in eine mit Graphit ausgekleidete Stahlkanne gefüllt, bei 400°C für 2h entgast und nach Verschweißen der Kanne bei 1050°C bei 150 MPa heißisostatisch gepresst. Der erhaltenen Körper weist eine Dichte von 99% der theoretischen Dichte auf und wird mit einer Diamantsäge in Scheiben geschnittene und über Schleifen zu 75 mm Targetscheiben verarbeitet. Die so hergestellten Sputtertargets weisen typischerweise einen spezifischen elektrischen Widerstand von weniger als 1 Ohm*cm auf.

Targetherstellung -Verfahrensweise 3

Für die Herstellung des Sputtertargets ist auch thermisches Spritzen geeignet, beispielsweise Plasmaspritzen von Rohrtargets unter Einsatz einer Mischung aus Molybdän-Pulver (metallisch) und ZnO-Agglomeraten mit Agglomerat-Größen im Bereich von z.B. 10 bis 70 $\mu$m. Die Bereichsgrenzen ergeben sich jeweils als $d_{10}$-Wert beziehungsweise als $d_{90}$-Wert dieser Teilchengrößenverteilung. Das Molybdän-Pulver liegt dabei feinteilig mit Korngrößen von weniger als 20 $\mu$m vor, vorzugsweise mit einer Teilchengrößenverteilung, die gekennzeichnet ist durch einen $d_{10}$-Wert von 2 $\mu$m und einen $d_{90}$ -Wert von 10 $\mu$m.

Schichtsystemherstellung mittels Target nach Verfahrensweise 1

Unter Verwendung des Sputtertargets nach Verfahrensweise 1 wird die zweilagige Schichtstruktur S1, S2 auf einem Glassubstrat 3 der Größe 2 cm x 2 cm und einer Dicke von 1,0 mm mittels DC-Sputtern aufgebracht. Auf das Glassubstrat 3 wird zunächst eine 49 nm dicke erste Schicht S1 aufgebracht und darauf anschließend eine 424 nm dicke zweite Schicht S2.

Die Sputterparameter sind dabei wie folgt:

Restgasdruck:      $2 * 10^{-6}$ mbar
Prozessdruck:      $3 * 10^{-3}$ mbar bei 200 sccm Argon
Spezifische

(fortgesetzt)

| Kathodenleistung: | 5 W/cm² |
|---|---|
| Schicht S1: | Target: 68,6 Gew.-% ZnO + 31,4 Gew.-% Mo; d = 49 nm, zusätzlicher Sauerstoffstrom: 50 sccm |
| Schicht S2: | Target: 68,6 Gew.-% ZnO + 31,4 Gew.-% Mo; d = 424 nm, zusätzlicher Sauerstoffstrom: 10 sccm. |

Im diesem Beispiel werden somit beide Schichten S1, S2 von ein und demselben Target gesputtert, das ZnO und einen Anteil an metallischem Molybdän von 31,4 Gew.-% enthält. Die unterschiedlichen Sauerstoff-Stöchiometrien werden dabei nur durch den Sauerstoffstrom beim Sputtern eingestellt. Beim Sputtern der Absorberschicht S2 wurde der Sputter-Atmosphäre weniger Sauerstoff hinzugefügt als beim Sputtern der Antireflexschicht S1.

Dabei entspricht ein Sauerstoffstrom von 50 sccm (das sind im Ausführungsbeispiel 20 Vol.-% Sauerstoff in der Sputter-Atmosphäre) einem Sauerstoffstrom, der technologisch noch problemlos gefahren werden kann.

Die Schicht S1 ist unter diesen Bedingungen nahezu volloxidisch, während S2 in etwa den Sauerstoffmangel des Targetwerkstoffs aufweist. Um voll dielektrische Schichten von einem volloxidischen Target zu erhalten, ist unter den gegebenen Bedingungen ein anlagenspezifischer Sauerstoffstrom erforderlich, um den Verlust an Sauerstoff durch die Pumpen auszugleichen. Der erforderliche Sauerstofffluss für voll dielektrische Schichten ergibt sich in erster Näherung aus dem Metallgehalt (Sauerstoffmangel) des eingesetzten Targets für diese Schicht. Für unterschiedliche Sputteranlagen und Target-Mischungen ist der entsprechende Wert durch wenige Versuche zunächst zu ermitteln und der Sauerstofffluss dementsprechend anzupassen. Die so hergestellte Schichtstruktur zeichnet sich unter anderem durch folgende Eigenschaften aus:

- Schichtwiderstand: RY = 555 kΩ/square
- Visuelle Reflexion (nach Abzug von ca. 4 % Reflexion durch Messung von der unbeschichteten Substratseite): 0,8 %. Visuelle Transmission: 0,1 %
- Der Absorptionskoeffizient Kappa der hergestellten Schichtstruktur 1 liegt für die Wellenlänge 550 nm bei 0,737.

Weitere vorteilhafte Ausführungsformen des Schichtsystems und zusätzliche Schichteigenschaften sind in Tabelle 1 genannt.

In Tabelle 2 sind für die Proben 1 bis 7 die Depositionsparamater und die dazugehörigen Messergebnisse an den abgeschiedenen Schichten zusammengefasst.

**Tabelle 2 (Beispiele ZnO+Mo/Abscheidebedingungen)**

| Nr. | Matrix | S1 Mo [Gew%] | S1 d [nm] | O2 flow S1 [sccm] | S2 Mo [Gew%] | S2 d [nm] | O2 flow S2 [sccm] |
|---|---|---|---|---|---|---|---|
| 1 | ZnO | 31,4 | 49 | 40 | 31,4 | 424 | 10 |
| 2 | ZnO | 37,9 | 50 | 50 | 31,4 | 423 | 10 |
| 3 | ZnO | 37,9 | 55 | 50 | 37,9 | 307 | 0 |
| 4 | ZnO | 31,4 | 55 | 40 | 37,9 | 308 | 0 |
| 5 | ZnO | 31,4 | 48 | 40 | 31,4 | 252 | 0 |
| 6 | ZnO | 37,9 | 49 | 50 | 31,4 | 252 | 0 |
| 7 | ZnO | 37,9 | 56 | 50 | 37,9 | 322 | 0 |

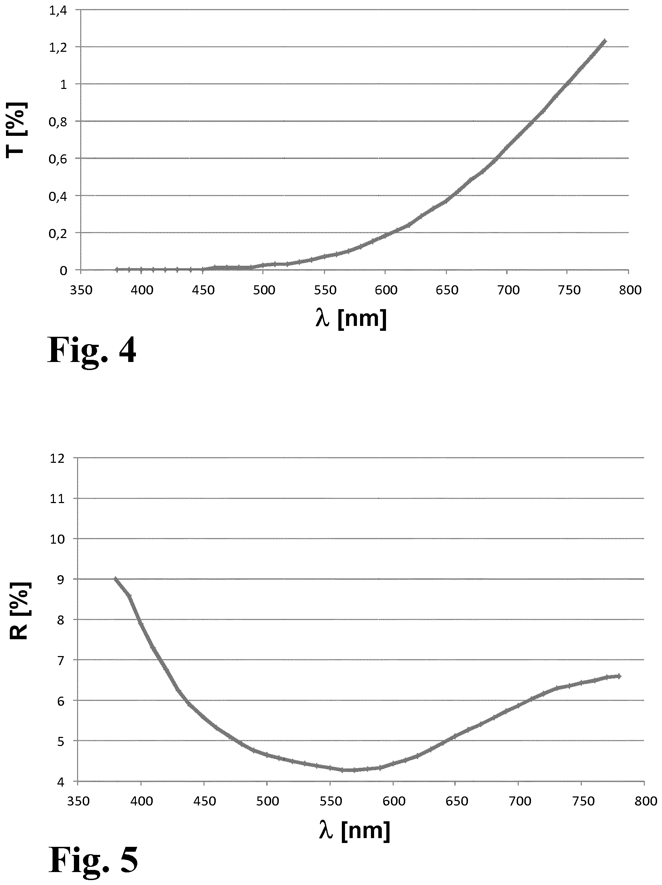

In **Figur 4** ist für das Schichtsystem gemäß Figur 1 und Probe 1 aus Tabelle 1 die Transmission T (in %) gegen die Messwellenlänge λ (in nm) aufgetragen. Demnach nimmt die Transmission T über den Wellenlängenbereich von 380 nm bis 780 nm mit der Wellenlänge zu, bleibt aber unterhalb von 1,4 %.

**Figur 5** zeigt für dieses Schichtsystem den Verlauf der Reflexion R (in %) über den Wellenlängenbereich λ (in nm) von 380 nm bis 780 nm. Die Reflexion zeigt ein Minimum bei etwa 555 nm mit einem Reflexionswert von etwas mehr als 4 %. Sie bleibt aber über den gesamten Wellenlängenbereich unterhalb von 9%, so dass sich nach Abzug eines Reflexionswertes von 4 %, der auf Reflexion an der nicht entspiegelten Glasplatten-Vorderseite zurückzuführen ist, eine tatsächlich dem Schichtsystem zuzuschreibende Reflexion unterhalb von 5 % ergibt.

Bei Lagerung der Schichtstruktur bei 18-24°C und 50-60 % relativer Luftfeuchtigkeit über bis zu 5 Tage haben sich die optischen Eigenschaften nur unwesentlich verändert. Die Änderung von Rv und Tv lag jeweils unter einem Prozentpunkt.

Das Schichtsystem lässt sich ohne Bildung störender Metallpartikel mittels verdünnter, fluorfreier Säuren ätzen und auch in Lösungen aus $KOH+H_2O_2$ oder unter Zusatz von $NH_4HF_2$ strukturieren. Auch bei anderen Ätzverfahren, wie beispielsweise Plasmaätzen zeigt sich keinerlei störende Partikelbildung. Versuche zum Ätzverhalten der Basiswerkstoffe laut Tabelle 3 und von Modifikationen dieses Werkstoffs werden weiter unten noch näher betrachtet.

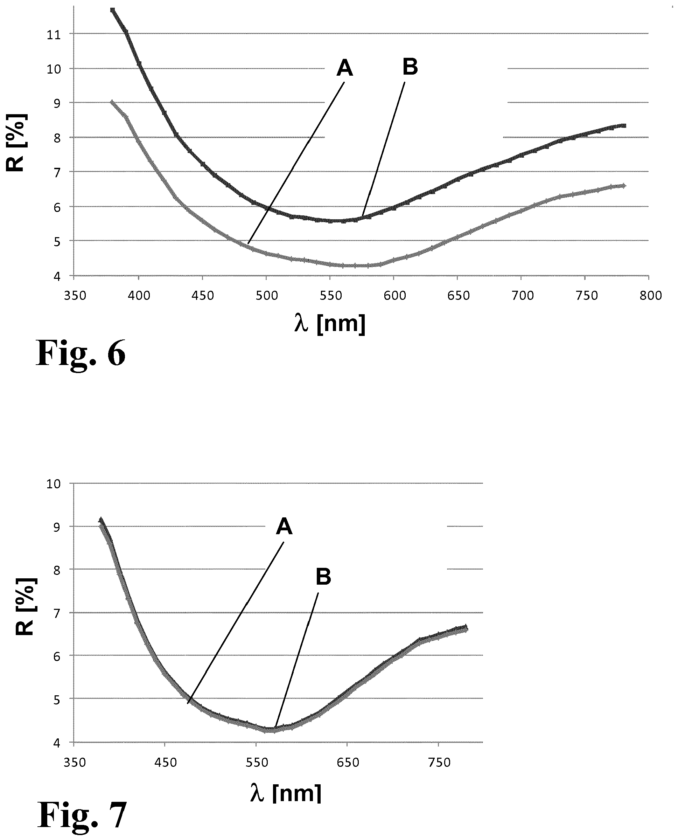

**Figur 6** zeigt einen Vergleich der spektralen Reflexionsverläufe von Probe Nr. 1 (Kurve A) und von Probe Nr. 4 (Kurve B) von Tabelle 1. Die Reflexion R (in %) ist über den Wellenlängenbereich λ (in nm) aufgetragen. Bei Probe Nr. 4 hat die Absorberschicht S2 einen vergleichsweise höheren Molybdänoxidgehalt. Es zeigt sich, dass der höhere Molybdänoxid-Gehalt in der Absorberschicht S2 zu einer höheren Reflexion des Schichtsystems insgesamt führt.

Im Sinne einer geringen Reflexion des Schichtsystems sollte daher der Molybdänoxid-Gehalt des Schichtsystems möglichst niedrig sein (im Ausführungsbeispiel 31,4 Gew.-% (die aus dem Molybdänoxid abzuleitende Masse an Molybdänmetall bezogen auf die Gesamtmasse der Absorberschicht)), wenn sowohl die Absorberschicht S2 als auch die Antireflexschicht S1 aus derselben Targetwerkstoff erzeugt werden sollen.

Demgegenüber zeigt der Vergleich der Reflexionskurven der Proben 1 und 2 (von Tabelle 1) von **Figur 7,** bei der ebenfalls die Reflexion R (in %) über den Wellenlängenbereich λ (in nm) aufgetragen ist, dass sich ein höherer Molybdänoxid-Gehalt in der Antireflexschicht S1 (wie bei Probe 2) auf die Reflexion des Schichtsystems nicht auswirkt. Hier verlaufen die Kurven A und B über den gesamten Wellenlängenbereich übereinander.

Beispiel 2: Schichtsysteme aus Leiterbahn und Absorberschicht

Ein weiteres Schichtsystem gemäß der Erfindung betrifft "schwarze Leiterbahnen". Diese bestehen aus einer dünnen Basisschicht aus Al, Cu, Mo oder Ti oder aus Legierungen dieser Metalle, die durch einen Überzug aus unterstöchiometrischem Zink-Molybdän-Oxid mit geeignet gewählter Schichtdicke nahezu schwarz erscheinen und dabei eine gute elektrische Leitfähigkeit aufweisen.

Folgende Eigenschaften lassen sich mit einem derartigen Schichtsystem erzielen:

Tv <8%, bevorzugt <4%

Rv < 15%

Schichtwiderstand < 100Ω/square

einfaches Nass-Ätzen, z.B. mit verdünnten Säuren auf der Basis von $HNO_3$, HCl, Oxalsäure, Essig, Phosphorsäure (auch Mischungen dieser Säuren) oder fluoridhaltigen Verbindungen wie beispielsweise $NH_4HF_2$ geringe Schichtdicke < 100 nm, bevorzugt <60nm.

Die Schichtreihenfolge ist hierbei: Substrat/Metall/schwarze Absorberschicht. Bei einem alternativen Ausführungsbeispiel des erfindungsgemäßen Schichtsystems ist die Schichtreihenfolge umgekehrt, nämlich: Glassubstrat/schwarze Absorberschicht/Metall.

In **Tabelle 3** sind Schichtparameter und Messergebnisse für ein Schichtsystem aus Aluminium-Leiterbahnen mit unterschiedlichen Dicken der Leiterbahnen $d_{Al}$ und der Absorberschichten $d_{Abs}$ aus ZnO+31,4 Gew.-% Mo zusammengefasst:

**Tabelle 3**

| $d_{Al}$ [nm] | $d_{Abs}$ [nm] | Tv [%] | Rv [%] | RΥ [Ω] |
|---|---|---|---|---|
| 10 | 40 | 10 | 9,5 | 13 |
| 15 | 35 | 5,2 | 20,1 | 7,7 |
| 20 | 30 | 2,6 | 35,1 | 4,1 |
| 10 | 45 | 8,9 | 6,1 | 13 |
| 15 | 45 | 4,2 | 6,3 | 4,1 |

In **Tabelle 4** sind Schichtparameter und Messergebnisse für ein Schichtsystem aus Aluminium-Leiterbahnen mit unterschiedlichen Dicken der Leiterbahnen $d_{Al}$ und der Absorberschichten $d_{Abs}$ aus ZnO+37,9 Gew.-% Mo zusammengefasst:

**Tabelle 4**

| $d_{Al}$ [nm] | $d_{Abs}$ [nm] | Tv [%] | Rv [%] | RΥ [Ω] |
|---|---|---|---|---|
| 10 | 40 | 7,3 | 11,6 | 12,5 |
| 15 | 35 | 4,2 | 11,6 | 7,5 |
| 20 | 30 | 2,3 | 19,7 | 12,5 |
| 10 | 45 | 6,1 | 13,3 | 12,5 |
| 15 | 45 | 3,0 | 10,7 | 4,0 |

Der Vergleich zum Schichtsystem von Tabelle 3 zeigt, dass der höhere MolybdänOxidgehalt der Absorberschichten von Tabelle 4 (37,9 Gew.-% im Vergleich zu 31,4 Gew.-%) bei gleicher Schichtdicke zu einer geringeren visuellen Transmission des Schichtsystems insgesamt führt. Die metallischen Leiterbahnen sind bei den geringen vorliegenden Dicken noch teildurchsichtig und können von der Messstrahlung durchstrahlt werden.

Die optischen Schichteigenschaften bleiben auch bei längerer Lagerung an Luft unverändert. Auch eine Temperaturbehandlung bei 150-200°C unter Schutzgas führt zu keiner nennenswerten Schichtveränderung.

In **Figur 8** sind für das Schichtsystem $d_{Al}$=15 nm und $d_{Abs}$=45 nm (siehe letzte Zeile von Tabelle 4) die Transmission T (in %) und die Reflexion R (in %) gegen die Messwellenlänge λ (in nm) aufgetragen. Die Transmission T steigt mit der Wellenlänge leicht an und liegt über einen gesamten Wellenlängenbereich von 380 nm bis 780 nm unterhalb von 5 %. Der Kurvenverlauf der Reflexion R zeigt bei einer Wellenlänge um 510 nm ein Minimum bei etwa 4 % und liegt ansonsten deutlich unterhalb von 20 %.

Die Herstellung der Sputtertargets erfolgt wie oben anhand der Verfahrensweisen 1 und 2 erläutert. Die Absorberschichten werden erzeugt, indem das entsprechende Sputtertarget ohne Sauerstoff-Zugabe abgesputtert und als Schicht auf der Leiterbahn niedergeschlagen wird.

Entsprechende Beschichtungen wurden auch auf Leiterbahnen aus anderen Metallen erzeugt. Dabei ergaben sich folgende Bereiche für den Widerstand des Schichtsystems: R/square (Al) < 15 Ohm; R/square (Cu) < 15 Ohm; R/square (Mo) < 100 Ohm.

Es hat sich gezeigt, dass bei der Herstellung besonders dünner Leiterbahnen eine vergleichsweise hohe Sputterleistung (beispielsweise mehr als 5 W/cm$^2$) erforderlich ist, um eine gute Leitfähigkeit zu erhalten. Dies gilt insbesondere für Leiterbahnen aus Aluminium, da die Metallatome bei geringer Sputterleistung (und damit geringer Abscheidegeschwindigkeit) zu schnell im Restgas oxidieren können.

Darüber hinaus hat sich gezeigt, dass bei Schichten hergestellt von Targets mit Molybdängehalten von mehr als 31 Gew.-% (berechnet als Relation des elementaren Gehalts an Molybdänmetall bezogen auf die Gesamtmasse der Absorberschicht, wie oben erläutert) die visuelle Transmission abnimmt, aber die visuelle Reflexion ansteigt. Die Qualität der Entspiegelung nimmt ab. Dicke metallische Schichten lassen sich schlechter entspiegeln als dünne Metallschichten. Zu dünne Metallschichten führen jedoch zu geringer Absorption. Die in dieser Hinsicht minimal erlaubte Dicke ist abhängig von der wellenlängenabhängigen Absorption des Metalls. Hier erlaubt Aluminium die dünnsten Metallschichten, gefolgt vom Kupfer.

Die folgenden **Tabellen 5 und 6** fassen die Daten dünner Metallschichten aus Molybdän (Tabelle 5) und Kupfer (Tabelle 6) mit den entsprechenden Leiterbahn-Dicken $d_{Mo}$ beziehungsweise $d_{cu}$ für Schichtsysteme mit Absorberschichten hergestellt von einem Target aus ZnO+Mo 37,9 Gew.-% beziehungsweise Absorberschichten von einem Target aus ZnO+Mo 31,4 Gew.-% zusammen, wobei die Dicke der jeweiligen Absorberschichten mit $d_{Abs}$ bezeichnet ist.

**Tabelle 5**

| ZnO-Mo37,9 Gew.-% | | | | ZnO-Mo31,4 Gew.-% | |
|---|---|---|---|---|---|
| $d_{Mo}$ [nm] | $d_{Abs}$ [nm] | $T_v$ [%] | $R_v$ [%] | $T_v$ [%] | $R_v$ [%] |
| 18 | 30 | 7,2 | 29 | 8,4 | 31,3 |
| 18 | 32 | 6,9 | 27 | 8,2 | 28,9 |
| 18 | 35 | 6,6 | 24,3 | 8 | 25,4 |

(fortgesetzt)

| ZnO-Mo37,9 Gew.-% | | | | ZnO-Mo31,4 Gew.-% | |
|---|---|---|---|---|---|
| $d_{Mo}$ [nm] | $d_{Abs}$ [nm] | $T_v$ [%] | $R_v$ [%] | $T_v$ [%] | $R_v$ [%] |
| 18 | 40 | 5,9 | 21 | 7,6 | 20 |
| 28 | 30 | 3,6 | 25,3 | 4,2 | 29,6 |
| 28 | 32 | 3,5 | 23,1 | 4,1 | 26,7 |
| 28 | 35 | 3,3 | 20,4 | 4 | 22,7 |
| 28 | 40 | 2,9 | 17,5 | 3,8 | 16,7 |
| 30 | 30 | 3,1 | 24,7 | 3,6 | 29,1 |
| 30 | 32 | 3 | 22,5 | 3,6 | 26,2 |
| 30 | 35 | 2,8 | 19,9 | 3,5 | 22,1 |
| 30 | 40 | 2,5 | 17,1 | 3,3 | 16,2 |
| 32 | 30 | 2,7 | 24,1 | 3,2 | 28,6 |
| 32 | 32 | 2,6 | 22 | 3,1 | 25,7 |
| 32 | 35 | 2,5 | 19,4 | 3 | 21,6 |
| 32 | 40 | 2,2 | 16,9 | 2,8 | 15,8 |
| 35 | 30 | 2,2 | 23,5 | 2,6 | 27,8 |
| 35 | 32 | 2,1 | 21,4 | 2,5 | 25 |
| 35 | 35 | 2 | 19 | 2,4 | 20,9 |
| 35 | 40 | 1,8 | 16,6 | 2,3 | 15,2 |

**Tabelle 6**

| ZnO-Mo37,9 Gew.-% | | | | ZnO-Mo31,4 Gew.-% | |
|---|---|---|---|---|---|
| $d_{cu}$ [nm] | $d_{Abs}$ [nm] | $T_v$ [%] | $R_v$ [%] | $T_v$ [%] | $R_v$ [%] |
| 40 | 30 | 6,7 | 10,3 | 9,1 | 9 |
| 40 | 32 | 6,2 | 10,9 | 8,7 | 7,5 |
| 40 | 35 | 5,6 | 12,4 | 8,1 | 5,9 |
| 40 | 40 | 4,7 | 15,8 | 7,1 | 5,1 |
| 45 | 30 | 5,1 | 9,6 | 6,9 | 9 |
| 45 | 32 | 4,7 | 10,3 | 6,6 | 7,3 |
| 45 | 35 | 4,2 | 11,8 | 6,2 | 5,6 |
| 45 | 40 | 3,5 | 15,4 | 5,4 | 4,7 |
| 50 | 30 | 3,8 | 9,2 | 5,2 | 9 |
| 50 | 32 | 3,6 | 9,8 | 5 | 7,2 |
| 50 | 35 | 3,2 | 11,4 | 4,6 | 5,4 |
| 50 | 40 | 2,7 | 15,1 | 4,1 | 4,4 |

Einstellung der Ätzgeschwindigkeit des Targetwerkstoffs

Um das Ätzverhalten des Schichtwerkstoffs in einem technisch relevanten Umfang verändern zu können, wurde dem Target-Basiswerkstoff eine Zusatzkomponente K3 hinzugefügt, wobei die relativ leicht ätzbare oxidische Komponente K1 (in den obigen Ausführungsbeispielen: ZnO) durch eine schwerer ätzbare Zusatzkomponente K3 teilweise ersetzt wurde. Deren Einfluss auf das Ätzverhalten wurde anhand mehrerer Versuchsreihen überprüft.

Bei diesen Versuchsreihen wurde der jeweilige Anteil der Zusatzkomponente K3 in Vol.-% angegeben. Die Umrechnung auf die vorher verwendeten Konzentrationsangaben in Gew.-% erfolgt auf Basis der spezifischen Dichten der einzelnen Komponenten, wie etwa folgende: Mo: 10,20 g/cm$^3$; ZnO: 5,62 g/cm$^3$; Nb$_2$O$_5$: 4,55 g/cm$^3$. Tabelle 7 zeigt das Umrechnungsergebnis für verschiedene binäre ZnO-Mo-Zusammensetzungen des Basiswerkstoffs.

**Tabelle 7**

| Mo Vol.-% | Mo Gew.-% | ZnO Vol.-% | ZnO Gew.-% |
|---|---|---|---|
| 5 | 8,78 | 95 | 91,22 |
| 20 | 31,38 | 80 | 68,62 |
| 25 | 37,88 | 75 | 62,12 |

In einer ersten Versuchsreihe wurde dem Basiswerkstoff ZnO+25 Vol.-% Mo schrittweise das im Vergleich zu ZnO schwerer ätzbare Oxid Nb$_2$O$_5$ als Zusatzkomponente K3 beigemischt. Dabei wurde ZnO ersetzt bis hinauf zu einem Gehalt von 50 vol.-% Nb$_2$O$_5$ im Target (und der daraus erzeugten Absorberschicht).

In einer weiteren Versuchsreihe wurde als Zusatzkomponente K3 TiO$_2$ anstelle von Nb$_2$O$_5$ eingesetzt.

Die so hergestellten Targetwerkstoffe und die daraus erzeugten Schicht enthielten somit stets 25 Vol.-% metallisches Mo sowie 75 Vol.-% an Oxiden der Komponente K1 und K3, wobei zur Verbesserung der elektrischen Leitfähigkeit des Sputtertargets die Oxide der Zusatzkomponente Nb$_2$O$_5$ beziehungsweise TiO$_2$ leicht unterstöchiometrisch vorlagen (etwa 1-10% Sauerstoffunterschuss bezogen auf den stöchiometrischen Sauerstoffgehalt).

Die Zusammensetzungen der jeweiligen Targetwerkstoffe, die Targetbezeichnungen (Spalte: "Probe") und die spezifischen resultierenden Dichten sowie die Angaben zu den spezifischen Widerständen p (in mΩcm) in sind in den Tabellen 8 und 9 spezifiziert.

**Tabelle 8**

| Probe | Mo Vol.-% | Mo Gew.-% | ZnO Vol.-% | ZnO Gew.-% | Nb$_2$O$_3$ Vol.-% | Nb$_2$O$_3$ Gew.-% | Dichte g/cm$^3$ | ρ mΩcm | Kappa @550nm |
|---|---|---|---|---|---|---|---|---|---|
| X1 | 25 | 38,18 | 70 | 58,44 | 5 | 3,38 | 6,732 | 37 | 0,75 |
| X2 | 25 | 38,48 | 65 | 54,70 | 10 | 6,81 | 6,678 | | 0,81 |
| X3 | 25 | 38,80 | 60 | 50,90 | 15 | 10,30 | 6,625 | | 0,86 |
| X4 | 25 | 39,11 | 55 | 47,04 | 20 | 13,85 | 6,571 | 33 | 0,90 |
| X5 | 25 | 39,76 | 45 | 39,12 | 30 | 21,12 | 6,464 | 31 | 0,99 |
| X6 | 25 | 40,43 | 35 | 30,94 | 40 | 28,63 | 6,357 | 14 | 1,08 |
| X7 | 25 | 41,12 | 25 | 22,48 | 50 | 36,40 | 6,250 | 7,4 | 1,18 |

**Tabelle 9**

| Probe | Mo Vol.-% | Mo Gew.-% | ZnO Vol.-% | ZnO Gew.-% | TiO$_2$ Vol.-% | TiO$_2$ Gew.-% | Dichte $^3$ g/cm | $\rho$ m$\Omega$cm | Kappa @550nm |
|---|---|---|---|---|---|---|---|---|---|
|  |  |  |  |  |  |  |  |  |  |
| **X8** | 25 | 40,42 | 45 | 39,77 | 30 | 19,81 | 6,359 | 18 | 1,05 |

Von den Targets gemäß Tabellen 8 und 9 wurden jeweils Absorberschichten von Schichtsystemen (Doppelschichten) durch DC-Sputtern in Argon ohne Sauerstoff-zugabe hergestellt. Der Absorptionskoeffizient kappa (gemessen bei einer Wellenlänge von 550 nm) der so hergestellten Absorberschichten ist in den Tabelle 8 und 9 angegeben. Demnach werden ähnlich gute Werte wie bei den in Tabelle 1 genannten Schichtstrukturen erzielt.

Analog wurde auf einer dünnen Metallschicht auf Basis von Al, Mo, Ti, Cu die Absorberschicht aufgesputtert, wie oben erläutert. Die Dicken der einzelnen Schichten der so erzeugten Schichtsysteme entsprechen denjenigen der Tabellen 3 bis 6.

Die Targetwerkstoffe gemäß den Tabellen 8 und 9 wurden auch zur Herstellung schwarzer Schichtstapel eingesetzt, indem auf einem Glassubstrat zunächst eine dünne Antireflexschicht abgeschieden und darauf eine Absorberschicht erzeugt wird, wie oben erläutert. Die jeweiligen Antireflexschichten können aus den für diesen Zweck allgemein bekannten Werkstoffen erzeugt werden. Vorzugsweise werden Antireflexschicht und Absorberschicht jedoch wie schon oben beschrieben durch Sputtern ein und desselben Targetwerkstoffs erzeugt, wobei beim Abscheiden der Absorberschicht die Sputter-Atmosphäre kein oder nur einen geringen Gehalt an Reaktivgas aufweist und die Antireflexschicht mit Sauerstoffzugabe gesputtert wird so, dass sie fast dielektrisch wird und noch etwa 4% Sauerstoffmangel aufweist. Die Dicken der einzelnen Schichten der so erzeugten Schichtsysteme entsprechen denjenigen der Tabelle 2.

Die Ätzgeschwindigkeiten wurden an Sputterschichten aus dem Targetwerkstoff gemessen. Hierzu wurden jeweils 100 nm dicke Absorberschichten (Einzelschicht) ohne Reaktivgas von den jeweiligen Targets gesputtert. Die Schichten wurden bei 20°C in einer Ätzlösung solange geätzt bis sie optisch transparent und rückstandsfrei waren. Die Zeit bis zum vollständigen Verschwinden der Sputterschicht wurde als Ätzdauer notiert. Die Ätzlösung hat folgende Zusammensetzung:

785ml H$_2$O
215ml H$_2$O$_2$
30g K$_2$S$_2$O$_5$
15g H$_5$F$_2$N (=NH$_4$HF$_2$)

Für jeden der genannten Targetwerkstoffe wurde die Messung 10-mal wiederholt. Der daraus erhaltene Mittelwert der Ätzdauer t (in s) und die sich daraus ergebenden spezifischen Ätzraten v (in nm/s) sind in Tabelle 10 angegeben. Als Referenzwert dient die Probe X0 (entspricht der Probe 2 aus Tabelle 1), die den Target-Basiswerkstoff ohne zusätzliche Zusatzkomponente K3 repräsentiert.

**Tabelle 10**

| Probe | Mo Vol.-% | ZnO Vol.-% | K3 Vol.-% | t [s] | v nm/s |
|---|---|---|---|---|---|
| **X0** | 25 | 75 | 0 | 98 | 1,53 |
| **X1** | 25 | 70 | 5 | 114 | 1,31 |
| **X4** | 25 | 55 | 20 | 240 | 0,63 |
| **X5** | 25 | 45 | 30 | 321 | 0,48 |
| **X6** | 25 | 35 | 40 | 354 | 0,42 |
| **X7** | 25 | 25 | 50 | 422 | 0,36 |
| **X8** | 25 | 45 | 30 | 194 | 0,77 |

Bei den Proben X1 bis X7 ist die Zusatzkomponente K3 = Nb$_2$O$_3$ (aus Tabelle 8); bei Probe X8 ist die Zusatzkomponente K3 = TiO$_2$ (aus Tabelle 9). Der Vergleich der Proben X0 bis X7 zeigt, dass bei gleicher Art der Zusatzkomponente K3 die Ätzrate der Absorberschicht mit steigendem Gehalt an Zusatzkomponente abnimmt. Dabei skalieren Anteil an Zusatzkomponente K3 und Ätzrate, wie das Diagramm von **Figur 10** zeigt. Darin ist die Ätzdauer t (in s) gegen den Volumenanteil C der Zusatzkomponente K3 aufgetragen.

Infolge der linearen Abhängigkeit von Ätzrate und Zusammensetzung kann die spezifische Ätzgeschwindigkeit auch für höhere Gehalte an Zusatzkomponente K3 und für andere Zusammensetzungen des Targetwerkstoffs mit anderen als den oben genannten Zusatzkomponenten K3 einfach und mit hinreichender Genauigkeit ermittelt werden. Auf diese Weise kann die Ätzrate des Schicht-Werkstoffs einfach an das jeweilige anwendungsspezifische Erfordernis angepasst werden.

Proben X2 bis X7 wurden zusätzlich einem sogenannten "Pressure Cooker Test" nach DIN EN 60749-33 unterzogen. Dabei werden die Proben 1h im Autoklaven behandelt: Heißdrucklagerung in 100 % rel. Feuchte / 121 $\pm$ 2 C°/ 202 kPa). Es wurde danach eine nur geringe - akzeptable - Abnahme der Transmission um 1% beobachtet.

**Figur 11** zeigt den Verlauf der Reflexion R (in %) über den Wellenlängenbereich $\lambda$ (in nm) von 350 nm bis 750 nm. Die Reflexion wurde hierbei von der Substratseite (Glas) gemessen; die angegeben Reflexionswerte enthalten etwa 4% der Reflexion des Glassubstrats.

Die durchgezogene Kurve A repräsentiert folgendes Schichtsystem:

|  |  |
|---|---|
| | Glassubstrat |
| Absorberschicht: | ZnO - Mo 25vol% - $Nb_2O_3$ 20vol%; Dicke: 40 nm |
| Metallschicht: | Mo; Dicke: 50 nm. |

Die visuelle Transmission dieses Schichtsystems liegt bei 0,7%. Das Abscheiden der dünnen Absorberschicht erfolgte durch Absputtern des Sputtertargets ohne Sauerstoffzugabe (kein Reaktivgas in der Sputter-Atmosphäre)

Die mit gestrichelter Linie gekennzeichnete Kurve B repräsentiert folgendes Schichtsystem:

|  |  |
|---|---|
| | Glassubstrat |
| Antireflexschicht: | ZnO - Mo 25vol% - $Nb_2O_3$ 5vol%; Dicke: 60 nm |
| Absorberschicht: | ZnO - Mo 25vol% - $Nb_2O_3$ 20vol%; Dicke: 250 nm |

Die visuelle Transmission dieses Schichtsystems liegt bei 2,7%. Das Abscheiden der dünnen Antireflexschicht erfolgte hierbei durch Absputtern des Sputtertargets in einer Sputter-Atmosphäre mit 23% Sauerstoff (genauer: 60 sccm Sauerstoff + 200 sccm Argon).

Außer den anhand der obigen Ausführungsbeispiele ausgeführten Zusatzkomponente K3 Nioboxid und Titanoxid vermindern auch Hafniumoxid, Tantaloxid, Vanadiumoxid und Aluminiumoxid die Ätzrate des Target-Basiswerkstoffs.

Beispiel 5: Einlagige schwarze Absorberschicht

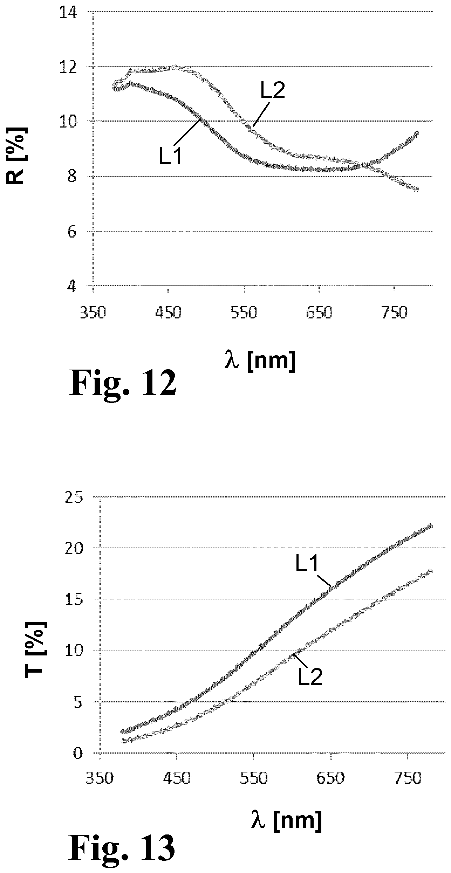

Eine auf einem Glassubstrat abgeschiedene einlagige Absorberschicht S2 (ohne Antireflexschicht S1) mit der chemischen Zusammensetzung der Probe 1 von Tabelle 1 erweist sich als visuell undurchsichtig und schwarz. Die **Figuren 12 und 13** zeigen den Verlauf der Reflexion R (in %) beziehungsweise der Transmission T (in %) über den Wellenlängenbereich $\lambda$ (in nm) von 350 nm bis 750 nm. Die dunkelgraue Kurve L1 ist dabei jeweils einer dünnen einlagigen Absorberschicht mit einer mittleren Schichtdicke von 125 nm zuzuordnen, und die hellgraue Kurve L2 einer im Mittel 145 nm dicken einlagigen Absorberschicht.

Die visuelle Reflexion der dünneren Absorberschicht L1 beträgt 8,9% und die der dickeren Absorberschicht L2 beträgt 10%. Die an der Unterseite des Glassubstrats gemessene Reflexion bleibt über den gesamten Wellenlängenbereich unterhalb von 12%. Im Bereich der Wellenlängen, die der maximalen Augenempfindlichkeit bei Tageslicht entsprechen (um 550 nm) liegen die Reflexionswerte sogar um 10% oder darunter, so dass sich in diesem Wellenlängenbereich nach Abzug des Reflexionswertes von 4 % (Reflexion an der nicht entspiegelten Glasplatten-Vorderseite) eine der Absorberschicht tatsächlich zuzuschreibende Reflexion um 6 % ergibt.

Die Transmission T steigt über den Wellenlängenbereich mit der Wellenlänge von Werten um 3 % an und erreicht bei 750 nm Werte um 18 % (Kurve L2; dickere Schicht) beziehungsweise um 22 % (Kurve L1, dünnere Schicht), was erscheint damit visuell weitgehend undurchsichtig.

**Patentansprüche**

1. Licht absorbierende Schicht (S2), die bei einer Wellenlänge von 550 nm einen Absorptionsindex kappa von mehr als 0,7 aufweist, aus einem Schichtwerkstoff

  • mit einer oxidischen Matrix, basierend auf einer Basiskomponente K1, ausgewählt aus der Gruppe bestehend aus Zinkoxid, Zinnoxid und/oder Indiumoxid, und auf einer Zusatzkomponente K3, die die Basiskomponente K1 zu einem Anteil "y" zwischen 0 und 75 Gew.-% ersetzt und die ausgewählt ist aus der Gruppe bestehend aus Nioboxid, Hafniumoxid, Titanoxid, Tantaloxid, Vanadiumoxid, Yttriumoxid, Zirkonoxid, Aluminiumoxid und Mischungen davon,
  • wobei in der Matrix eine Schwärzungskomponente K2 verteilt ist, ausgewählt aus der Gruppe bestehend aus Molybdän, Wolfram und Legierungen und Mischungen davon, wobei die Schwärzungskomponente K2 entweder als Metall oder als unterstöchiometrisch-oxidische oder als unterstöchiometrisch-oxinitridische Verbindung des Metalls vorliegt, derart, dass der Schichtwerkstoff einen Reduktionsgrad aufweist, der durch einen Sauerstoffgehalt von maximal 65 % des stöchiometrisch maximalen Sauerstoffgehalts definiert ist, und wobei der Anteil "x" der Schwärzungskomponente K2 - berechnet aus dem Gewicht ihres elementaren Anteils bezogen auf das Gewicht des Schichtwerkstoffs im Bereich zwischen 20 und 50 Gew.-% liegt.

2. Licht absorbierende Schicht nach Anspruch 1, **dadurch gekennzeichnet, dass** für den Anteil x, in Gew.-% des Schichtwerkstoffs, der Schwärzungskomponente K2 gilt:

   $x \geq 25$, vorzugsweise
   $30 \leq x \leq 40$.

3. Licht absorbierende Schicht nach Anspruch 1 oder 2, **dadurch gekennzeichnet, dass** der Schichtwerkstoff eine vorgegebene spezifische Soll-Ätzrate hat und der Anteil y, in Gew.-%, der Zusatzkomponente K3 in Abhängigkeit von der Soll-Ätzrate eingestellt ist, wobei gilt:

   $0 \leq y < 15$, oder
   $15 \leq y < 30$, oder
   $30 \leq y < 45$, oder
   $45 \leq y < 60$, wobei vorzugsweise gilt:
   $y \leq 100/3$.

4. Licht absorbierende Schicht nach einem der vorhergehenden Ansprüche, **dadurch gekennzeichnet, dass** der Schichtwerkstoff eine optisch homogene und amorphe Struktur hat in dem Sinne, dass er keine mittels Röntgendiffraktometermessungen erfassbaren kristallinen Strukturen aufweist.

5. Licht absorbierende Schicht nach einem der vorhergehenden Ansprüche, **dadurch gekennzeichnet, dass** die Schwärzungskomponente K2 als unterstöchiometrische oxidische oder unterstöchiometrische oxinitridische Sauerstoffverbindung des Metalls oder als Metall vorliegt und dass der Schichtwerkstoff einen Reduktionsgrad aufweist, der durch einen Sauerstoffgehalt von zwischen 30 und 65 %, vorzugsweise zwischen 40 und 60 % des theoretisch maximal möglichen Sauerstoffgehalts definiert ist.

6. Licht absorbierendes Schichtsystem, umfassend die Licht absorbierende Schicht nach einem der Ansprüche 1 bis 5 als eine dem Betrachter abgewandte Absorberschicht in Verbindung mit einer dem Betrachter zugewandten Antireflexschicht (S1), wobei das Schichtsystem im Wellenlängenbereich von 380 bis 780 nm durch eine visuelle Transmission Tv von weniger als 2 %, eine visuelle Reflexion Rv von weniger als 6 % gekennzeichnet ist.

7. Licht absorbierendes Schichtsystem nach Anspruch 6, **dadurch gekennzeichnet, dass** seine visuelle Transmission Tv weniger als 1 %, vorzugsweise weniger als 0.2 % und seine visuelle Reflexion Rv weniger als 3 % beträgt.

8. Licht absorbierendes Schichtsystem nach Anspruch 6 oder 7, **dadurch gekennzeichnet, dass** die Licht absorbierende Schicht eine Schichtdicke von weniger als 600 nm, vorzugsweise im Bereich von 250 bis 450 nm hat, und dass die Schichtdicke der Antireflexschicht im Bereich von 45 bis 60 nm liegt.

9. Licht absorbierendes Schichtsystem, umfassend die Licht absorbierende Schicht nach einem der Ansprüche 1 bis 5 als eine einem Betrachter zugewandte Absorberschicht in Verbindung mit einer dem Betrachter abgewandten und als Leiterbahn dienenden metallischen Schicht.

10. Licht absorbierende Schichtsystem mach Anspruch 9, **dadurch gekennzeichnet, dass** die metallische Schicht ein oder mehrere der Metalle enthält, ausgewählt aus der Gruppe: Al, Mo, Cu, Ti.

11. Licht absorbierendes Schichtsystem nach Anspruch 9 oder 10, **dadurch gekennzeichnet, dass** die Kombination aus metallischer Schicht und Absorberschicht im Wellenlängenbereich von 380 bis 780 nm eine visuelle Transmission Tv weniger als 8 %, vorzugsweise weniger als 4 % und eine visuelle Reflexion Rv von weniger als 15 % aufweist.

12. Licht absorbierendes Schichtsystem nach Anspruch 11, **dadurch gekennzeichnet, dass** es eine Gesamtdicke von weniger als 90 nm, bevorzugt weniger als 60 nm aufweist.

13. Licht absorbierendes Schichtsystem nach einem der Ansprüche 9 bis 12, **dadurch gekennzeichnet, dass** es einen Schichtwiderstand von weniger als 100 Ohm/square aufweist.

14. Licht absorbierendes Schichtsystem nach einem der Ansprüche 9 bis 13, **dadurch gekennzeichnet, dass** die metallische Schicht aus Aluminium oder einer Aluminium-Basislegierung besteht und eine Dicke im Bereich von 17 bis 21 nm hat, und dass die Dicke der Absorberschicht im Bereich von 30 bis 50nm liegt und bevorzugt maximal 40 nm beträgt.

15. Licht absorbierendes Schichtsystem nach einem der Ansprüche 9 bis 13, **dadurch gekennzeichnet, dass** die metallische Schicht aus Molybdän oder einer Molybdän-Basislegierung besteht und eine Dicke im Bereich von 15 bis 50 nm, bevorzugt im Bereich von 25 bis 35 nm hat, und dass die Dicke der Absorberschicht im Bereich von 35 bis 50 nm liegt und bevorzugt maximal 40 nm beträgt.

16. Licht absorbierendes Schichtsystem nach einem der Ansprüche 9 bis 13, **dadurch gekennzeichnet, dass** die metallische Schicht aus Kupfer oder einer Kupfer-Basislegierung besteht und eine Dicke im Bereich von 40 bis 50 nm hat, und dass die Dicke der Absorberschicht im Bereich von 28 bis 50 nm liegt und bevorzugt maximal 40 nm beträgt.

17. Sputtertarget, insbesondere zur Herstellung einer Licht absorbierenden Schicht nach einem der Ansprüche 1 bis 5 oder eines Licht absorbierenden Schichtsystems nach einem der Ansprüche 6 bis 16, **dadurch gekennzeichnet, dass** es aus einem Targetwerkstoff besteht,

 • mit einer oxidischen Matrix, basierend auf einer Basiskomponente K1, ausgewählt aus der Gruppe bestehend aus Zinkoxid, Zinnoxid und/oder Indiumoxid, und auf einer Zusatzkomponente K3, die die Basiskomponente K1 zu einem Anteil "y" zwischen 0 und 75 Gew.-% ersetzt und die ausgewählt ist aus der Gruppe bestehend aus Nioboxid, Hafniumoxid, Titanoxid, Tantaloxid, Vanadiumoxid, Yttriumoxid, Zirkonoxid, Aluminiumoxid und Mischungen davon,
 • wobei in der Matrix eine Schwärzungskomponente K2 verteilt ist, ausgewählt aus der Gruppe bestehend aus Molybdän, Wolfram und Legierungen und Mischungen davon, wobei die Schwärzungskomponente K2 entweder als Metall und/oder als unterstöchiometrisch-oxidische oder unterstöchiometrisch-oxinitridische Verbindung des Metalls vorliegt, derart, dass das Target einen Reduktionsgrad aufweist, der durch einen Sauerstoffgehalt von maximal 65 % des stöchiometrisch maximalen Sauerstoffgehalts definiert ist und wobei der Anteil "x" der Schwärzungskomponente K2 - berechnet aus dem Gewicht ihres Metall-Anteils bezogen auf das Gewicht des Targetwerkstoffs im Bereich zwischen 20 und 50 Gew.-% liegt.

18. Sputtertarget nach Anspruch 17, **dadurch gekennzeichnet, dass** der Anteil der Schwärzungskomponente K2 mindestens 25 Gew.-% beträgt und vorzugsweise im Bereich zwischen 30 und 45 Gew.-% liegt.

19. Sputtertarget nach 18, **dadurch gekennzeichnet, dass** die Schwärzungskomponente K2 in metallischer Form vorliegt.

20. Sputtertarget nach einem der Anspruch 17 bis 19, **dadurch gekennzeichnet, dass** der Anteil y der Zusatzkomponente K3 in Abhängigkeit von einer Soll-Ätzrate einer aus dem Sputtertarget herzustellenden Schicht zwischen 0 und <15 Gew.-%, zwischen 15 und < 30 Gew.-%, zwischen 30 und < 45 Gew.-% oder zwischen 45 und 60 Gew.-% liegt und besonders bevorzugt maximal ein Drittel des Gewichts der Basiskomponente K1 ersetzt.

21. Sputtertarget nach 20, **dadurch gekennzeichnet, dass** die Zusatzkomponente K3 als Oxid, bevorzugt als leitfähiges leicht unterstöchiometrisches Oxid vorliegt.

22. Sputtertarget nach einem der Ansprüche 17 bis 21, **dadurch gekennzeichnet, dass** der Targetwerkstoff eine Dichte von mehr als 95 % der theoretischen Dichte und einen Gehalt an Verunreinigungen von weniger als 500 Gew.-ppm und einen Reduktionsgrad aufweist, der durch einen Sauerstoffgehalt von zwischen 30 und 65 %, vorzugsweise zwischen 40 und 60 % des theoretisch maximal möglichen Sauerstoffgehalts definiert ist.

23. Verfahren zur Herstellung des Schichtsystems nach einem der Ansprüche 6 bis 16, umfassend die Abscheidung einer Licht absorbierenden Schicht durch DC- oder MF-Sputtern eines Sputtertargets nach einem der Ansprüche 17 bis 22, in einer Sputter-Atmosphäre, die ein Edelgas und ein Reaktivgas in Form von Sauerstoff und/oder Stickstoff enthält, wobei der Reaktivgasgehalt in der Sputter-Atmosphäre auf maximal 10 Vol.-%, bevorzugt auf maximal 4 Vol.-% eingestellt wird.

24. Verfahren nach Anspruch 23, **dadurch gekennzeichnet, dass** zur Abscheidung der Antireflexschicht und zur Abscheidung der Absorberschicht ein Sputtertarget mit nominal gleicher Zusammensetzung eingesetzt wird, wobei die Sputter-Atmosphäre bei der Abscheidung der Antireflexschicht einen höheren Reaktivgasgehalt hat als bei der Abscheidung der Absorberschicht, derart, dass sich in der Antireflexschicht ein Sauerstoffunterschuss einstellt, der weniger als 5% beträgt.

**Claims**

1. Light-absorbing layer having, at a wavelength of 550 nm, an absorption index kappa of more than 0.7, made from a layer material comprising:

    an oxidic matrix based on a base component K1 selected from the group consisting of zinc oxide, tin oxide and/or indium oxide, and on an added component K3 which replaces the base component K1 up to a fraction y between 0 and 75% by weight, and which is selected from the group consisting of niobium oxide, hafnium oxide, titanium oxide, tantalum oxide, vanadium oxide, yttrium oxide, zirconium oxide, aluminum oxide and mixtures thereof; and
    whereby in the matrix a blackening component K2 is dispersed, selected from the group consisting of molybdenum, tungsten and alloys and mixtures thereof, whereby the blackening component being present either as (i) a metal or (ii) a substoichiometric-oxidic or a substoichiometric-oxynitride compound of the metal, such that the layer material has a degree of reduction which is defined by an oxygen content of not more than 65% of the stoichiometrically maximum oxygen content, and wherein the fraction "x" of the blackening component K2 being calculated from a weight of its elemental fraction based on a weight of the layer material and being in the range between 20 and 50% by weight.

2. The light-absorbing layer according to claim 1, **characterized in that** for fraction x in wt.% of the layer material of the blackening component K2 applies:

    $x \geq 25$, preferably
    $30 \leq x \leq 40$

3. The light-absorbing layer according to claim 1 or 2, **characterized in that** the layer material has a predetermined specific target etch rate and the fraction y of the added component K2 in wt. % is set in response to the target etch rate, and wherein the fraction y of the added component K2 in wt. % is one of:

    $0 \leq Y < 15$;
    $15 \leq Y < 30$;
    $30 \leq Y < 45$;
    $45 \leq Y < 60$; and wherein preferably
    $Y \leq 100/3$

4. The light-absorbing layer according to anyone of the preceding claims, **characterized in that** the layer material has an optically homogeneous and amorphous structure, such that it is without crystalline structures that are detectable by way of X-ray diffractometer measurements.

5. The light-absorbing layer according to anyone of the preceding claims, **characterized in that** the blackening component K2 is present as a substoichiometric-oxidic or substoichiometric-oxynitride oxygen compound of the metal or as a metal, and **in that** the layer material has a degree of reduction which is defined by an oxygen content between 30% and 65%, preferably between 40 and 60% of the stoichiometrically maximally possible oxygen content.

6. A light-absorbing layer system comprising:

the light-absorbing layer according to any of claims 1 to 5 as an absorber layer facing away from a viewer, in connection with
an antireflection layer (S1) facing the viewer,
wherein, in the wavelength range of 380 nm to 780 nm, the light-absorbing layer system is **characterized by** a visual transmission Tv of less than 2% and a visual reflection Rv of less than 6%.

7. The light-absorbing layer system according to claim 6, **characterized in that** the visual transmission Tv is less than 1%, preferably less than 0,2% and the visual reflection Rv is less than 3%.

8. The light-absorbing layer system according to claim 6 or 7, **characterized in that** the light-absorbing layer has a layer thickness of less than 600 nm, preferably in the range of 250 to 450 nm, and **in that** the layer thickness of the antireflection layer is in the range of 45 nm to 60 nm.

9. A light-absorbing layer system comprising:

the light-absorbing layer according to anyone of claims 1 to 5 as an absorber layer facing a viewer, in connection with
a metallic layer which faces away from the viewer and serves as a conductor path.

10. The light-absorbing layer system according to claim 9, **characterized in that** the metallic layer contains one or more of the metals selected from the group of Al, Mo, Cu, and Ti.

11. The light-absorbing layer system according to claim 9 or 10, **characterized in that** in the wavelength range of 380 nm to 780 nm, the combination of the metallic layer and absorber layer has a visual transmission Tv of less than 8%, preferably of less than 4% and a visual reflection Rv of less than 15%.

12. The light-absorbing layer system according to claim 11, **characterized in that** it has a total thickness of less than 90 nm, preferably less than 60 nm.

13. The light-absorbing layer system according to anyone of claims 9 to 12, **characterized in that** it has a layer resistance of less than 100 ohm/square.

14. The light-absorbing layer system according to anyone of claims 9 to 13, **characterized in that** the metallic layer consists of aluminum or of an aluminum base alloy and has a thickness in the range of 17 nm to 21 nm, and **in that** the thickness of the absorber layer is in the range of 30 nm to 50 nm, preferably is at most 40 nm.

15. The light-absorbing layer system according to anyone of claims 9 to 13, **characterized in that** the metallic layer consists of molybdenum or of an molybdenum base alloy and has a thickness in the range of 15 nm to 50 nm, preferably in the range of 25 to 35 nm, and **in that** the thickness of the absorber layer is in the range of 35 nm to 50 nm, preferably is at most 40 nm.

16. The light-absorbing layer system according to anyone of claims 9 to 13, **characterized in that** the metallic layer consists of copper or a copper base alloy and has a thickness in the range of 40 nm to 50 nm, and **in that** the thickness of the absorber layer is in the range of 28 nm to 50 nm, preferably is at most 40 nm.

17. A sputter target in particular for producing a light-absorbing layer according to anyone of claims 1 to 5 or of a light absorbing layer system according to any one of claims 6 to16, **characterized in that** it is consisting of a target material comprising:

an oxidic matrix based on a base component K1 selected from the group consisting of zinc oxide, tin oxide and indium oxide, and on an added component K3 which replaces the base component K1 at a fraction "y" between 0 and 75 wt. %, and which is being selected from the group consisting of niobium oxide, hafnium oxide, titanium oxide, tantalum oxide, vanadium oxide, yttrium oxide, zirconium oxide, aluminum oxide and mixtures thereof, and

a blackening component K2 distributed in the matrix, which is being selected from the group consisting of molybdenum, tungsten and alloys and mixtures thereof, the blacking component K2 being present as (i) a metal and/or (ii) a substoichiometric-oxidic or substoichiometric-oxynitride compound of the metal, such that the target material has a degree of reduction which is defined by an oxygen content of not more than 65% of the stoichiometrically maximal oxygen content, a fraction "x" of the blackening component K2 being calculated from a weight of its metal fraction based on a weight of the target material and being in the range between 20 and 50 wt. %.

18. The sputter target according to claim 17, **characterized in that** the fraction of the blackening component K2 is at least 25 wt. %, preferably is in the range of between 30 to 45%.

19. The sputter target according to claim 18, **characterized in that** the blackening component K2 is present in metallic form.

20. The sputter target according to anyone of claims 17 to 19, **characterized in that** the fraction y of the added component K3, in response to a target etch rate of a layer to be produced from the sputter target, is one of the following: between 0 and 15 wt. %, between 15 and 30 wt. %, between 30 and 45 wt. %, and between 45 and 60 wt. %, and most preferably replaces at most one third of the weight of the base component K1.

21. The sputter target according to claim 20, **characterized in that** the added component K3 is present as an oxide, preferably is present as a conductive, slightly sub-stoichiometric oxide.

22. The sputter target according to anyone of claims 17 to 21, **characterized in that** the target material has a density of more than 95% of the theoretical density, a content of impurities of less than 500 wt. ppm, and a degree of reduction which is defined by an oxygen content of between 30 and 65%, preferably between 40 and 60%, of the stoichiometrically maximally possible oxygen content.

23. A method for producing the light-absorbing layer system according to anyone of claims 6 to 16, the method comprising:

depositing a light-absorbing layer by DC or MF sputtering of a sputter target according to anyone of claims 17 to 22 in a sputter atmosphere containing a noble gas and a reactive gas in the form of oxygen and/or nitrogen, wherein a content of the reactive gas in the sputter atmosphere is set to not more than 10 vol. %, preferably to not more than 4 vol.%.

24. The method according to claim 23, **characterized in that** for deposition of the antireflection layer and for deposition of the absorber layer, a sputter target is used with nominally the same composition, wherein the sputter atmosphere during the deposition of the antireflection layer has a higher content of the reactive gas than during the deposition of the absorber layer, resulting in an oxygen deficit in the antireflection layer that is less than 5%.

**Revendications**

1. Couche absorbant la lumière (S2) qui, à une longueur d'onde de 550 nm, présente un indice d'absorption kappa supérieur à 0,7, constituée d'un matériau en couches

• avec une matrice d'oxyde, basée sur un composant de base K1, sélectionné dans le groupe constitué de l'oxyde de zinc, de l'oxyde d'étain et/ou de l'oxyde d'indium, et sur un composant supplémentaire K3, qui remplace le composant de base K1 à hauteur d'une part « y » comprise entre 0 et 75 % en poids et qui est sélectionné dans le groupe constitué de l'oxyde de niobium, de l'oxyde d'hafnium, de l'oxyde de titane, de l'oxyde de tantale, de l'oxyde de vanadium, de l'oxyde d'yttrium, de l'oxyde de zirconium, de l'oxyde d'aluminium et des mélanges de ceux-ci,
• un composant de noircissement K2, sélectionné dans le groupe constitué du molybdène, du tungstène et d'alliages et de mélanges de ceux-ci, étant réparti dans la matrice, le composant de noircissement K2 existant soit sous forme de métal, soit sous la forme d'un composé oxyde sous-stoechiométrique ou oxynitrure sous-stoechiométrique du métal, de façon à ce que le matériau en couches présente un degré de réduction qui est défini par une teneur en oxygène représentant au maximum 65 % de la teneur stoechiométrique maximale en oxygène et la part « x » du composant de noircissement K2, calculée à partir du poids de sa part élémentaire par rapport au poids du matériau en couches, est de l'ordre de 20 à 50 % en poids.

**2.** Couche absorbant la lumière selon la revendication 1, **caractérisée en ce que**, pour la part x, en pourcentage en poids du matériau en couches, du composant de noircissement K2, on a :

$x \geq 25$, de préférence
$30 \leq x \leq 40$.

**3.** Couche absorbant la lumière selon la revendication 1 ou 2, **caractérisée en ce que** le matériau en couches présente une vitesse de gravure de consigne spécifique prédéterminée et **en ce que** la part y, en pourcentage en poids, du composant supplémentaire K3, est ajustée en fonction de la vitesse de gravure de consigne, de sorte que :

$0 \leq y \leq 15$ ou
$15 \leq y \leq 30$ ou
$30 \leq y \leq 45$ ou
$45 \leq y \leq 60$, de préférence :
$y \leq 100/3$.

**4.** Couche absorbant la lumière selon l'une des revendications précédentes, **caractérisée en ce que** le matériau en couches présente une structure optiquement homogène et amorphe, dans le sens où il ne présente aucune structure cristalline pouvant être mesurée au moyen de mesures par diffraction de rayons X.

**5.** Couche absorbant la lumière selon l'une des revendications précédentes, **caractérisée en ce que** le composant de noircissement K2 existe sous la forme d'un composé oxygéné de type oxyde sous-stoechiométrique ou oxynitrure sous-stoechiométrique du métal ou sous forme de métal et **en ce que** le matériau en couches présente un degré de réduction qui est défini par une teneur en oxygène comprise entre 30 et 65 %, de préférence entre 40 et 60 %, de la teneur en oxygène maximum théoriquement possible.

**6.** Système de couches absorbant la lumière comprenant la couche absorbant la lumière selon l'une des revendications 1 à 5, sous la forme d'une couche absorbante, opposée à l'observateur, en lien avec une couche anti-réflexion (S1), orientée vers l'observateur,
le système de couches étant caractérisé, dans le domaine de longueurs d'ondes de 380 nm à 780 nm, par une transmission visuelle Tv inférieure à 2 %, une réflexion visuelle Rv inférieure à 6 %.

**7.** Système de couches absorbant la lumière selon la revendication 6, **caractérisé en ce que** sa transmission visuelle Tv est inférieure à 1 %, de préférence inférieure à 0,2 % et sa réflexion visuelle Rv est inférieure à 3 %.

**8.** Système de couches absorbant la lumière selon la revendication 6 ou 7, **caractérisé en ce que** la couche absorbant la lumière présente une épaisseur de couche inférieure à 600 nm, de préférence de l'ordre de 250 à 450 nm, et **en ce que** l'épaisseur de la couche anti-réflexion est de l'ordre de 45 à 60 nm.

**9.** Système de couches absorbant la lumière, comprenant la couche absorbant la lumière selon l'une des revendications 1 à 5 sous la forme d'une couche absorbante orientée vers un observateur, en lien avec une couche métallique opposée à l'observateur et servant de piste conductrice.

**10.** Système de couches absorbant la lumière selon la revendication 9, **caractérisé en ce que** la couche métallique contient un ou plusieurs métaux sélectionnés dans le groupe : Al, Mo, Cu, Ti.

**11.** Système de couches absorbant la lumière selon la revendication 9 ou 10, **caractérisé en ce que** la combinaison d'une couche métallique et d'une couche absorbante présente, dans le domaine de longueurs d'onde de 380 à 780 nm, une transmission visuelle Tv inférieure à 8 %, de préférence inférieure à 4 % et une réflexion visuelle Rv inférieure à 15 %.

**12.** Système de couches absorbant la lumière selon la revendication 11, **caractérisé en ce qu'**il présente une épaisseur totale inférieure à 90 nm, de préférence inférieure à 60 nm.

**13.** Système de couches absorbant la lumière selon l'une des revendications 9 à 12, **caractérisé en ce qu'**il présente une résistance de couche inférieure à 100 Ohm/carré.

**14.** Système de couches absorbant la lumière selon l'une des revendications 9 à 13, **caractérisé en ce que** la couche métallique est constituée d'aluminium ou d'un alliage à base d'aluminium et présente une épaisseur de l'ordre de 17 à 21 nm, et **en ce que** l'épaisseur de la couche absorbante est de l'ordre de 30 à 50 nm et de préférence au maximum de 40 nm.

15. Système de couches absorbant la lumière selon l'une des revendications 9 à 13, **caractérisé en ce que** la couche métallique est constituée de molybdène ou d'un alliage à base de molybdène et présente une épaisseur de l'ordre de 15 à 50 nm, de préférence de l'ordre de 25 à 35 nm et **en ce que** l'épaisseur de la couche absorbante est de l'ordre de 35 à 50 nm et de préférence au maximum de 40 nm.

16. Système de couches absorbant la lumière selon l'une des revendications 9 à 13, **caractérisé en ce que** la couche métallique est constituée de cuivre ou d'un alliage à base de cuivre et présente une épaisseur de l'ordre de 40 à 50 nm et **en ce que** l'épaisseur de la couche absorbante est de l'ordre de 28 à 50 nm et de préférence au maximum de 40 nm.

17. Cible de pulvérisation, plus particulièrement pour la fabrication d'une couche absorbant la lumière selon l'une des revendications 1 à 5 ou d'un système de couches absorbant la lumière selon l'une des revendications 6 à 16, **caractérisée en ce qu'**elle est constituée d'un matériau cible,

   • avec une matrice d'oxyde, basée sur un composant de base K1, sélectionné dans le groupe constitué de l'oxyde de zinc, de l'oxyde d'étain et/ou de l'oxyde d'indium, et sur un composant supplémentaire K3, qui remplace le composant de base K1 à hauteur d'une part « y » comprise entre 0 et 75 % en poids et qui est sélectionné dans le groupe constitué de l'oxyde de niobium, de l'oxyde d'hafnium, de l'oxyde de titane, de l'oxyde de tantale, de l'oxyde de vanadium, de l'oxyde d'yttrium, de l'oxyde de zirconium, de l'oxyde d'aluminium et des mélanges de ceux-ci,
   • un composant de noircissement K2, sélectionné dans le groupe constitué du molybdène, du tungstène et d'alliages et de mélanges de ceux-ci, étant réparti dans la matrice, le composant de noircissement K2 existant soit sous forme de métal, soit sous la forme d'un composé oxyde sous-stoechiométrique ou oxynitrure sous-stoechiométrique du métal, de façon à ce que le matériau cible présente un degré de réduction qui est défini par une teneur en oxygène représentant au maximum 65 % de la teneur stoechiométrique maximale en oxygène et la part « x » du composant de noircissement K2, calculée à partir du poids de sa part métallique par rapport au poids du matériau cible, est de l'ordre de 20 à 50 % en poids.

18. Cible de pulvérisation selon la revendication 17, **caractérisée en ce que** la part de composant de noircissement K2 est d'au moins 25 % en poids et, de préférence, compris entre 30 et 45 % en poids.

19. Cible de pulvérisation selon la revendication 17, **caractérisée en ce que** le composant de noircissement K2 existe sous forme métallique.

20. Cible de pulvérisation selon l'une des revendications 17 à 19, **caractérisée en ce que** la part y de composant supplémentaire K3, en fonction d'une vitesse de gravure de consigne d'une couche à fabriquer à partir de la cible de pulvérisation, est comprise entre 0 et < 15 % en poids, entre 15 et < 30 % en poids, entre 30 et < 45 % en poids ou entre 45 et 60 % en poids et remplace de préférence au maximum un tiers du poids du composant de base K1.

21. Cible de pulvérisation selon la revendication 20, **caractérisée en ce que** le composant supplémentaire K3 existe sous la forme d'un oxyde, de préférence sous la forme d'un oxyde conducteur légèrement sous-stoechiométrique.

22. Cible de pulvérisation selon l'une des revendications 17 à 21, **caractérisée en ce que** le matériau cible présente une densité supérieure à 95 % de la densité théorique et une teneur en impuretés inférieure à 500 ppm en poids et un degré de réduction qui est défini par une teneur en oxygène comprise entre 30 et 65 %, de préférence entre 40 et 60 % de la teneur en oxygène maximale possible théoriquement.

23. Procédé de fabrication du système de couches selon l'une des revendications 6 à 16, comprenant le dépôt d'une couche absorbant la lumière par pulvérisation DC ou MF d'une cible de pulvérisation selon l'une des revendications 17 à 22, dans une atmosphère de pulvérisation, qui contient un gaz noble et un gaz réactif sous la forme d'oxygène et/ou d'azote, la teneur en gaz réactif dans l'atmosphère de pulvérisation étant ajustée au maximum à 10 % en volume, de préférence au maximum à 4 % en volume.

24. Procédé selon la revendication 23, **caractérisé en ce que**, pour le dépôt de la couche anti-réflexion et pour le dépôt de la couche absorbante, une cible de pulvérisation avec une composition nominalement identique est utilisée, l'atmosphère de pulvérisation présentant, lors du dépôt de la couche anti-réflexion, une teneur en gaz réactif plus élevée que lors du dépôt de la couche absorbante, de façon à ce que la couche anti-réflexion présente un déficit en oxygène inférieur à 5 %.

Fig. 1

Fig. 2

Fig. 3

**Fig. 4**

**Fig. 5**

Fig. 6

Fig. 7

**Fig. 8**

**Fig. 9**

Fig. 10

Fig. 11

**Fig. 12**

**Fig. 13**

**IN DER BESCHREIBUNG AUFGEFÜHRTE DOKUMENTE**

**In der Beschreibung aufgeführte Patentdokumente**

- EP 2336811 A1
- EP 2116631 A1
- US 20070071985 A1
- CN 101158028 A
- JP 2002206166 A
- US 6048621 A

**In der Beschreibung aufgeführte Nicht-Patentliteratur**

- **KENNEDY, C.E.** Review of Mid- to High-Temperature Solar Selective Absorber Materials. *NREL Technical Report,* Juli 2002